# EUROPEAN PATENT SPECIFICATION

(11) **EP 4 107 476 B1**
(45) Date of publication and mention of the grant of the patent: **08.04.2026**
(21) Application number: 21756602.5
(22) Date of filing: 18.02.2021
(51) Int. Cl.: G01B 9/02, G01S 17/89, G01S 7/481, G02F 1/29, G01S 7/4912

(54) **BACKSIDE ILLUMINATION ARCHITECTURES FOR INTEGRATED PHOTONIC LIDAR**
RÜCKSEITENBELEUCHTUNGSARCHITEKTUREN FÜR INTEGRIERTEN PHOTONISCHEN LIDAR
ARCHITECTURES D'ÉCLAIRAGE DE CÔTÉ ARRIÈRE POUR UN LIDAR PHOTONIQUE INTÉGRÉ

(30) Priority: 19.02.2020 US 202062978452 P
(43) Date of publication of application: 28.12.2022
(73) Proprietor: Pointcloud Inc., San Francisco, CA 94107 (US)
(72) Inventor: PIGGOTT, Alexander Yukio, San Mateo, California 94403 (US); GONDARENKO, Alexander Alexeevich, San Jose, California 95125 (US); FORTUNE, Steven Andrew, Wanaka, 9305 (NZ); COMPSTON, Andrew James, San Francisco, California 94114 (US); WISER, Robert Francis, San Francisco, California 94115 (US); NICOLAESCU, Remus, San Francisco, California 94115 (US)
(74) Representative: E. Blum & Co. AG
(86) International application number: PCT/US2021/018563
(87) International publication number: WO 2021/168102

(56) References cited:
- EP-A1- 3 602 109
- US-A1- 2006 091 542
- US-A1- 2007 208 395
- US-A1- 2015 184 999
- US-A1- 2019 005 667
- US-A1- 2019 237 931
- US-A1- 2019 243 064
- US-A1- 2019 391 243
- US-A1- 2020 013 699
- US-A1- 2020 013 699
- US-B1- 9 709 668

## Description

### BACKGROUND

Conventional light detection and ranging systems (LIDAR) systems are bulky and difficult to integrate into a compact chip package in a commercially practical approach.

US20190237931A1 describes a flip chip backside Vertical Cavity Surface Emitting Laser (VCSEL) package that has a VCSEL pillar array. A first metal contact is formed over a top section of each pillar of the VCSEL pillar array. A second metal contact is formed on a back surface of the VCSEL pillar array. An opening is formed in the second metal contact and aligned with the pillars of the VCSEL pillar array. A solder tip is applied on each pillar of the VCSEL pillar array to flip chip mount the VCSEL pillar array.

EP3602109A1 concerns modulated image capture. Disclosed is a pixel element comprising a semiconductor substrate, a primary charge-collection node, a peripheral node, a modulating node, a circuitry and a backside conductive layer. The semiconductor substrate is configured to convert a flux of photons to first and second conductivity-type mobile charges. The peripheral node at least partially surrounds the primary charge-collection node, which at least partially surrounds the modulating node. The circuitry is used to connect and disconnect a reset voltage to/from the primary charge-collection node, provide a peripheral node voltage to the peripheral node, and measure an amount of the first conductivity-type mobile charges collected by the primary charge-collection node. The modulating node is electrically connected to a modulating voltage source, which is independent of the peripheral node voltage. The backside conductive layer is configured to collect and conduct the second conductivity-type mobile charges, and configured to be electrically connected to a bias voltage.

US 2020/013699 A1 concerns stacked microfluidic cooled 3D electronic-photonic integrated circuits. An electronic-photonic integrated-circuit assembly comprises a carrier substrate (310) and one or more integrated-circuit dies (330, 340) bonded to one another so as to form a die stack with exterior surfaces corresponding to an outer surface of a first one of the integrated-circuit dies and to an outer surface of a second one of the integrated-circuit dies, where at least one of the integrated-circuit dies includes one or more integrated photonic devices.

### SUMMARY

The invention is a backside light detection and ranging system and a method as defined in the appended claims.

### BRIEF DESCRIPTION OF THE DRAWINGS

To easily identify the discussion of any particular element or act, the most significant digit or digits in a reference number refer to the figure ("FIG.") number in which that element or act is first introduced.
FIG. 1 displays front-side illuminated (left) and backside-illuminated (right) image sensors, according to some example embodiments.
FIG. 2 displays a backside light detection and ranging system that can be utilized for integrated photonic LiDAR, according to some example embodiments.
FIG. 3 shows die-stacking of the photonic integrated circuit (PIC) and electronic integrated circuit (EIC) dies, according to some example embodiments.
FIG. 4 shows a 2.5D integration of a backside illuminated FPA-based LiDAR system using a combination of flip-chip bonding and wire bonding, according to some example embodiments.
FIG. 5 shows an alternate 2.5D integration method for backside illuminated FPA-based LiDAR system using a combination of flip-chip bonding and through-silicon vias (TSVs), according to some example embodiments.
FIG. 6 shows a 3D integration method for backside illuminated FPA-based LiDAR system using oxide-oxide wafer bonding between the EIC and PIC, according to some example embodiments.
FIG. 7 shows a backside illumination implementation with a shield placed in the lowest-level metal as a reflector, according to some example embodiments.
FIG. 8 shows a separate transmitter and receiver in a dual-path configuration for a LiDAR coherent 3D imaging camera, according to some example embodiments.
FIG. 9 shows a block diagram of transmitter, receiver and signal processor for a LiDAR based coherent 3D imaging camera.
FIG. 10 displays package assembly for monolithically integrated photonics and electronics, according to some example embodiments.
FIG. 11 displays a backside illumination configuration for significantly improving packing density on the chip since wiring can now be placed directly over the grating couplers, according to some example embodiments.
FIG. 12 shows an example PIC / EIC combo with backside illumination, according to some example embodiments.
FIG. 13 shows an example implementation of assembled PIC / EIC combo with integrated ADCs, multiplexer, serializer, and driver amplifier for a backside illumination configuration, according to some example embodiments.
FIG. 14 shows an example implementation of an EIC for backside illumination, according to some example embodiments.
FIG. 15 shows a system with 3 contacts per pixel, according to some example embodiments.
FIG. 16 shows a system with 2 contacts per pixel with a shared photodiode bias, according to some example embodiments.
FIG. 17 shows an implementation of 2-contact pixel with zero-biased photodiode, according to some example embodiments.
FIG. 18 shows an implementation of single-contact pixel with reverse-biased photodiodes, with bias and ground shared across multiple pixels, according to some example embodiments.
FIG. 19 shows an implementation of single-contact pixel with zero-biased photodiodes, with ground shared across multiple pixels, according to some example embodiments.
FIG. 20 shows an example with four active pixels, according to some example embodiments.
FIG. 21 shows an example implementation of a 1x2 optical switching element, according to some example embodiments.
FIG. 22 shows an example implementation of monitor and control circuitry for a 1x2 thermoptic switch, according to some example embodiments.
FIG. 23 displays an illustration of how the photonics can be separated from the electronics on separate dies, according to some example embodiments.
FIG. 24 shows an implementation of unit cells used in an optical switching tree, according to some example embodiments.
FIG. 25 shows a high-level schematic of an embodiment of a 1024 position optical switch, according to some example embodiments.
FIG. 26 shows an embodiment of a 1x64 switching tree, according to some example embodiments.
FIG. 27 shows an embodiment of a 32x32 grating array used in a 1024 position transmit array, according to some example embodiments.
FIG. 28 shows an embodiment of a 1024-position transmit array making use of a direct flip-chip interconnect between the PIC and EIC, according to some example embodiments.
FIG. 29 shows an embodiment of a 1024-position transmit array making use of a direct flip-chip interconnect between the PIC and EIC, according to some example embodiments.
FIG. 30 shows an embodiment of the 1024 position transmit array making use of a high-density interposer, according to some example embodiments.
FIG. 31 shows an illustration of a single-path LiDAR architecture, according to some example embodiments.
FIG. 32 shows a photonic circuit schematic of an embodiment of a dual-path receiver pixel, according to some example embodiments.
FIG. 33 shows photonic circuit schematic of an embodiment of a single-path transmit / receive pixel, according to some example embodiments.
FIG. 34 shows a standard grating coupler on a silicon photonics PIC, according to some example embodiments.
FIG. 35 a metal mirror can be used to direct all of the light emitted by a grating coupler towards the backside of the wafer, according to some example embodiments.
FIG. 36 shows a multi-layered grating coupler, , according to some example embodiments.
FIG. 37 shows a flow diagram of a method for implementing a backside light detection and ranging system to generate ranging and distance data of one or mor external objects, according to some example embodiments.
FIG. 38 shows an example pointcloud generated by the backside light detection and ranging system, according to some example embodiments.

### DETAILED DESCRIPTION

The description that follows includes systems, methods, techniques, instruction sequences, and computing machine program products that embody illustrative embodiments of the disclosure. In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, protocols, structures, and techniques are not necessarily shown in detail.

### LIDAR ARCHITECTURES

Described here are several different architectures of integrated photonic LiDAR that make use of backside illumination. By transmitting and receiving light through the backside (bottom) of the chip instead, it is possible to gain significant improvements in system performance, compactness, packaging, and cost.

Backside illumination for integrated photonic LIDAR: Integrated circuits are fabricated by starting with a substrate made of a semiconductor such as silicon. All the active components such as transistors and diodes are first formed on the top surface of the semiconductor. A layered stack of metal wires and dielectric insulators are then deposited on top of the active components, connecting the components together to form functional electrical circuits.

Image sensors, such as the CCD and CMOS sensors which are ubiquitous in today's digital cameras, are essentially specialized integrated circuits. Two architectures can be implemented. In a frontside illuminated architecture, light shines on the chip from the top side, and must pass through the wiring stack to reach the photodetector pixels residing on the top surface of the semiconductor substrate. Due to the need to route metal wires over the photodetectors, only a fraction of the light striking the sensor reaches the detectors, reducing the efficiency of the image sensor. Meanwhile, in a backside illuminated architecture, light shines on the chip from the bottom side, and directly strikes the photodetectors without passing through the wiring stack. The backside architecture increases LiDAR efficiency of the image sensor and can improve the photon collection efficiency by as much as a factor of two or more.

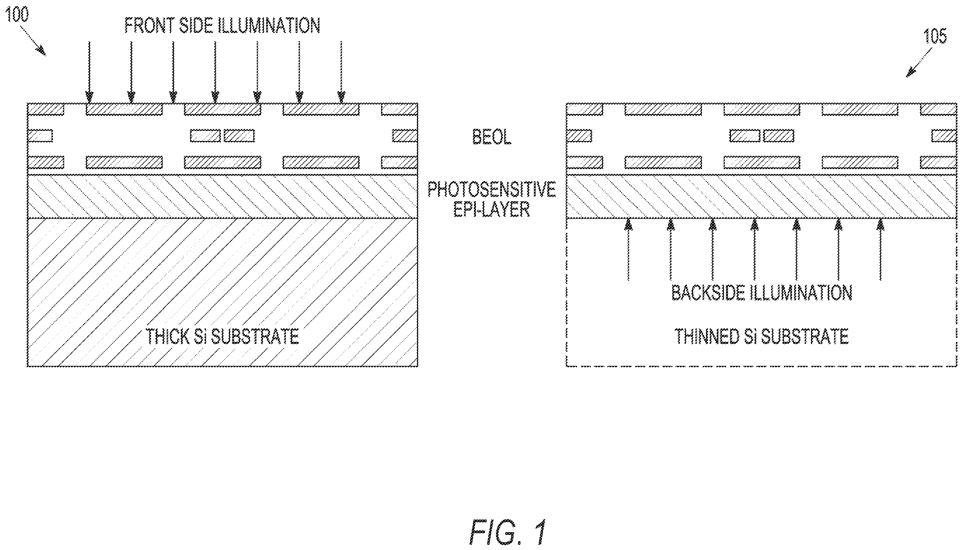

FIG. 1 displays a front-side illuminated image sensor 100 and backside-illuminated sensor 105, according to some example embodiments. The front-side illuminated sensor 100 collects light through a Back End Of Line (BEOL) wire stack on the front side of the chip. The backside illuminated sensor 105 collects light from the back side of the sensor, and avoids light scattering from the wire stack. However, a backside illuminated sensor 105 operating at visible wavelengths requires most of the supporting silicon substrate to be removed due to the absorption of visible light in silicon.

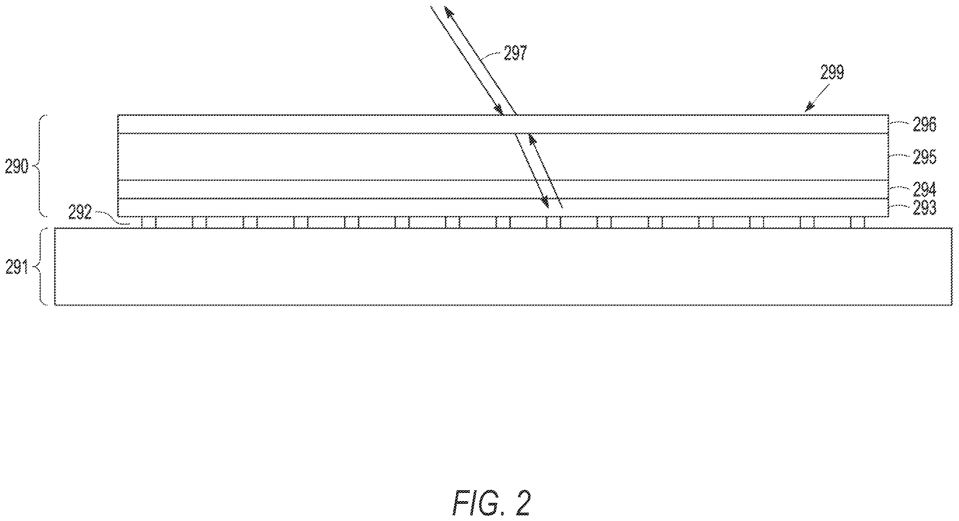

Backside illumination is implemented in an integrated photonic LiDAR architecture, as illustrated in FIG. 2. The example of FIG. 2 discusses a focal-plane array (FPA) based LiDAR implementation, whereby light is focused onto an array of LiDAR pixels by a lens, in a similar fashion to a camera. The backside illumination in an FPA-based integrated photonic LiDAR systems discussed herein confer a variety of advantages: (1) Metal wire routing no longer interferes with optical sensing, allowing pixels to be packed more closely together. (2) The front (top) surface of the chip is now available for flip-chip bonding, improving interconnect density and RF characteristics of the interconnects. This, in turn, enables novel LiDAR architectures which are not possible with front-side illumination. (3) Optical performance of the sensor may improve, since light no longer needs to travel through the wiring stack, which tends to absorb, scatter, and deflect light due to the presence of many different dielectric layers in the wiring stack, even in regions without any metal. Further, in contrast to image sensors, LiDAR sensors typically use long wavelengths of light (e.g. greater than 1000 nanometers (nm), 1550 nm light) to which the semiconductor substrate is completely transparent. This allows the semiconductor substrate of a backside-illuminated LiDAR sensor to remain relatively (e.g., greater than 100 of microns) thick, making fabrication and packaging significantly easier than for backside-illuminated image sensors. With reference to FIG. 2, the actual LiDAR sensor pixels reside in the Photonic Integrated Circuit 290 (PIC) and transmit and receive light 297 through the backside of the PIC. The light travels through the photonic device layer 293 (e.g., from a laser source), BOX 294, silicon bulk substrate 295, and an anti-reflective coating 296 deposited on the backside 299 of the PIC that faces away from the EIC. Further, a CMOS electronic chip 291 containing support electronics is flip-chip bonded to the frontside of the PIC using an interconnect structure 292 (e.g., electrical contacts such as copper pillars), enabling a very high interconnect density with excellent high-frequency performance, according to some example embodiments.

2.5D integration for backside illuminated LiDAR: As discussed above, one benefit of backside illumination for FPA-based LiDAR includes use of flip-chip interconnects between the photonic integrated circuit (PIC) and supporting electronics, which enable extremely high interconnect densities and better high-frequency (RF) performance. This, in turn, allows a significant amount of electrical functionality to be off-loaded from the PIC to an adjacent electronic integrated circuit (EIC).

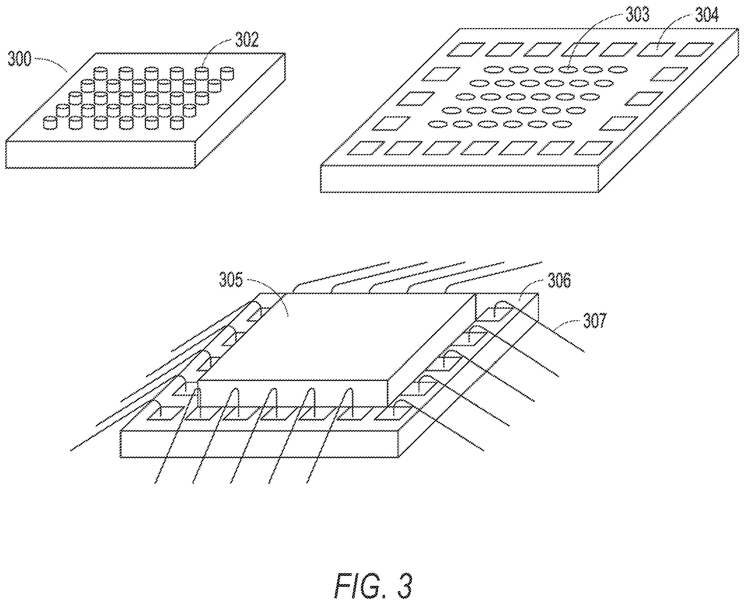

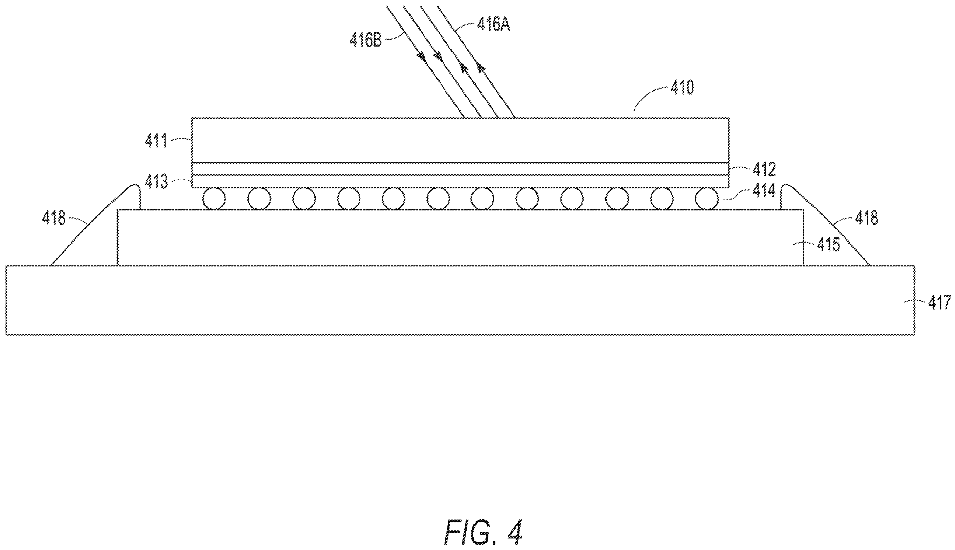

In FIG. 3 and FIG. 4, two example architectures are illustrated for 2.5D integration (e.g., stacking PIC and EIC dies using flip-chip interconnects), according to some example embodiments. In a first approach, the PIC and EIC are connected using either copper bump or C4 solder ball-based flip-chip interconnects. Further, the EIC is connected to the supporting printed-circuit board (PCB) using wire-bond interconnects.

FIG. 3 shows die-stacking of the photonic integrated circuit (PIC) and electronic integrated circuit (EIC) dies, according to some example embodiments. The front surface of the PIC 300 is populated with copper bumps, C4 solder balls, gold stud bumps, or similar high-density flip-chip interconnect 302, and the front surface of the EIC is populated with corresponding pads 303, in addition to pads for wire bonding 304. The PIC die is then flip-chipped 305 on top of the EIC 306 and connected using reflow soldering or eutectic bonding. Electrical signals to the PCB substrate are provided by wire bonds 307.

FIG. 4 shows a 2.5D integration of a backside illuminated FPA-based LiDAR system using a combination of flip-chip bonding and wire bonding, according to some example embodiments. The flip-chip PIC 410 consisting of a thick silicon substrate layer 411, a silicon dioxide spacer layer 412 (e.g., "buried oxide layer") and the active layer 413, sits on the top of the stack. Infrared light is transmitted 416A and received 416B by the active layer 413, passing through the silicon dioxide spacer layer 412 and the thick silicon substrate layer 411. The PIC 410 is electrically connected to the EIC 415 through a flip-chip interconnect 414. Meanwhile, the EIC 415 is electrically connected to the supporting PCB 417 via wire-bonds 418.

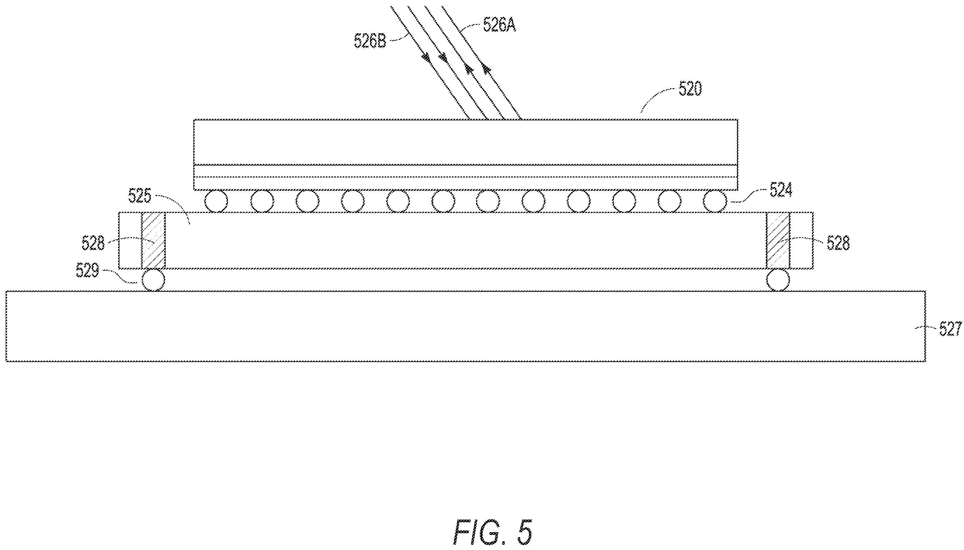

FIG. 5 shows an alternate 2.5D integration method for backside illuminated FPA-based LiDAR system using a combination of flip-chip bonding and through-silicon vias (TSVs) for transmitted 526A and received 526B light, according to some example embodiments. In this approach, illustrated in FIG. 5, flip-chip interconnects 524 are not only used between the PIC 520 and EIC dies, but also between the EIC die and the supporting PCB. This requires the use of through-silicon vias (TSVs) in the EIC, since electrical connections are made on both the front and backside of the EIC. This approach has a smaller form factor and improved high-frequency (RF) performance but higher IC and assembly costs compared to the previous approach.

Rather than making use of wire bonds as in FIG. 4, TSVs 528 and flip-chip interconnects 529 are used to electrically connect the EIC 525 to the PCB 527. Compared to the wirebonding approach, this has a smaller form factor, but results in more expensive ICs and assembly.

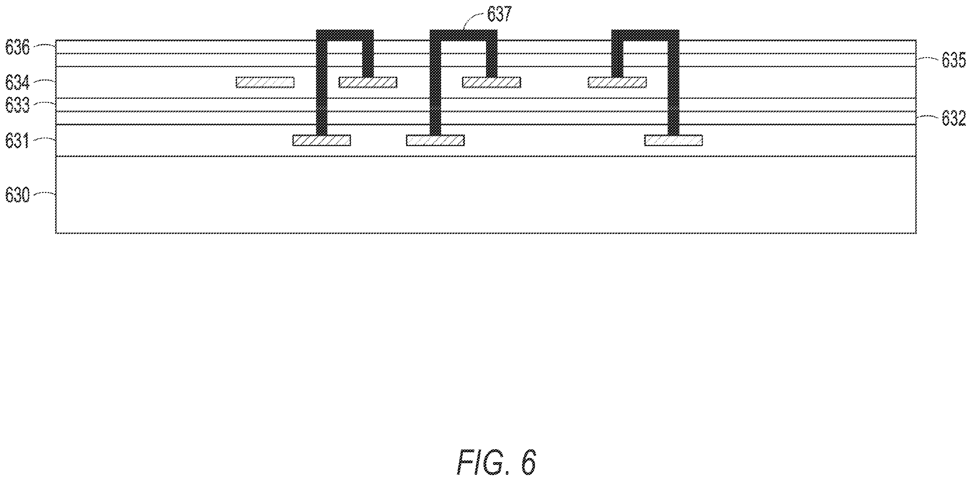

FIG. 6 shows a 3D integration method for backside illuminated FPA-based LiDAR system using oxide-oxide 632, 633 wafer bonding between the EIC 630-632 and PIC layers 633-636, according to some example embodiments. After bonding, the handle wafer 636 of the PIC is removed, leaving the BOX 635 as the top layer. By using metal from the EIC BEOL metal 631 and the PIC BEOL metal 634 as etch stops, high-density vias can be created between the EIC and PIC by depositing and patterning a metal layer 637. Electrical connection from the EIC to the PCB can follow techniques described in FIGs 4 or 5 and are not shown here.

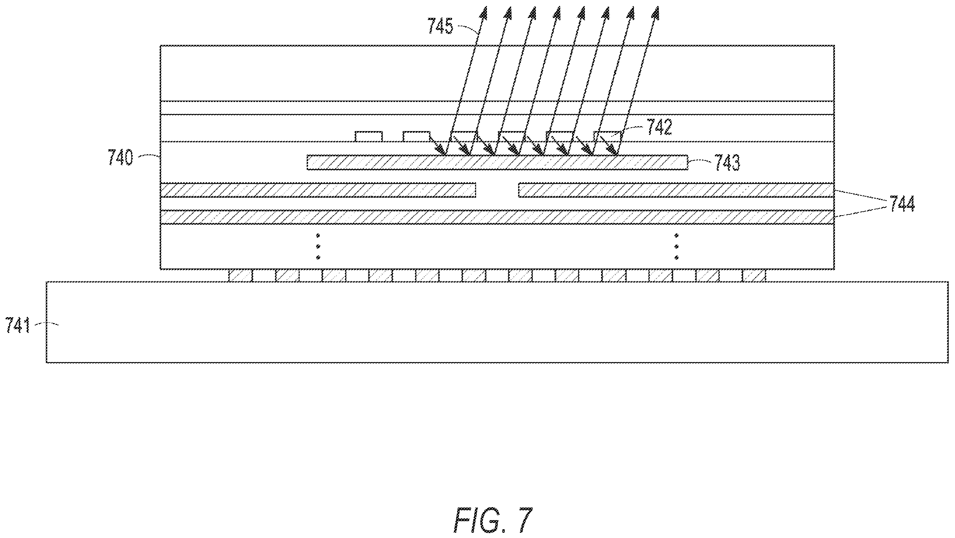

FIG. 7 shows a backside illumination implementation with a shield placed in the lowest-level metal as a reflector, according to some example embodiments. This approach creates an additional degree of freedom by optimizing the grating design for transmit efficiency through the backside against back-reflection and transmit angle. The PIC 740 is flip-chip assembled onto the EIC 741. The grating coupler 742 is designed to transmit light upwards through the backside of the PIC. To improve efficiency of upwards transmission, the lowest level metal 743 is placed as a reflector below the grating. Higher level metals 744 can still be used for signal and supply routing. Light transmitted downwards 745 is now reflected infrared light that is sent through the backside of the PIC. In another embodiment a metal higher in the BEOL stack can be used as the reflector.

In the embodiments shown above contain silicon or another semiconductor material. In the embodiments shown above the wavelength of light being used by the sensor in 1550nm or any other wavelength between 1300 nm and 1600 nm.

Dual path and single path LiDAR architectures: Below two different FPA-based LiDAR architectures, dual-path, and single-path, are discussed. In a dual-path architecture, the transmit pixels and receive pixels are separate, and can reside on separate integrated photonic chips, according to some example embodiments. In the single-path architecture, the transmit and receive functions are combined into a single pixel. Note, the single-path and dual-path architectures are equivalent to monostatic and pseudo-monostatic configurations in radar terminology. The single-path architecture uses the exact same optical antennas (e.g., grating couplers) for transmit and receive and is equivalent to a monostatic radar. Further, the dual-path architecture uses separate optical antennas for transmit and receive that are spaced only millimeters or centimeters apart, equivalent to a pseudo-monostatic radar where the transmit and receive antennas are separate but placed adjacent to each other.

### DUAL PATH ARCHITECTURES

In a dual-path focal-plane array (FPA) LiDAR, the transmit and receive pixels exist in separate arrays. The transmitter array consists of a waveguide-based optical switching tree terminated by grating couplers to outcouple the light. The optical switching tree can be configured to couple all the light out of any individual grating coupler, effectively steering the light beam. Further, the receiver array consists of an array of miniaturized heterodyne detectors. In some example embodiments, each transmit pixel corresponds to a number of receive pixels. For example, one transmit pixel may illuminate the field-of-view of eight (8) or more receive pixels.

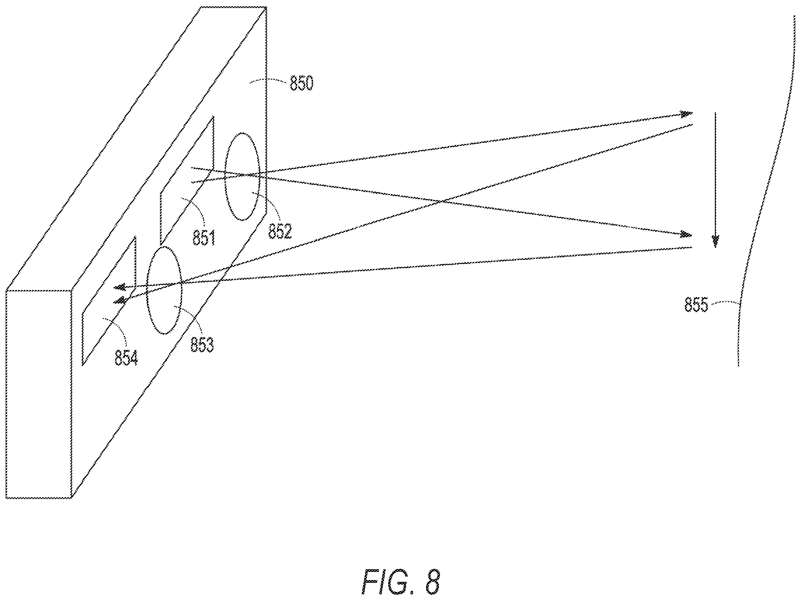

FIG. 8 shows a separate transmitter and receiver in a dual-path configuration for a LiDAR coherent 3D imaging camera 850, according to some example embodiments. A sample architecture is shown in FIG. 8 - an optical beam having a modulated optical frequency is directed perpendicular to the transmitter PIC 851 successively from a plurality of couplers on the surface of the PIC and collimated with the help of lens 852 and directed towards the region of interest 855. The function of directing the beam to a plurality of couplers on the surface of the chip is accomplished by an in plane optical switch. The scattered signal from region of interest 855 is captured by lens 853 and directed to the plurality of pixels located on the surface of receiver PIC 854 where couplers direct the light into the plane of the chip. Once on the plane of the chip the optical signal is combined with a copy of the local optical signal for each pixel of the receiver array and the frequency difference between the two signals is measured to generate LiDAR information (e.g., for each of the points, one or more of the following: range and distancing data, three orthogonal dimensional values (X, Y, Z), time of flight, velocity of the object that reflected a given point, radial velocity, doppler shift, and reflectivity of the target).

Receiver array with monolithically integrated photonics and electronics: The following descriptions discuss several different approaches of the dual-path FPA LiDAR with backside illumination. In a first approach, a chip fabrication process monolithically integrates photonics and electronics. In this approach, the photonic integrated circuit (PIC) die can have both integrated photonics components (e.g., optical waveguides, modulators, phase shifters, grating couplers, etc.) in addition to electrical components (e.g., transistors, resistors, capacitors, inductors, etc.). As a result, it is possible to monolithically integrate sophisticated electronic circuits such as amplifiers, multiplexers, analog-to-digital converters (ADCs), digital-to-analog converters (DACs), and digital control circuitry, in addition to optical circuits, on the PIC.

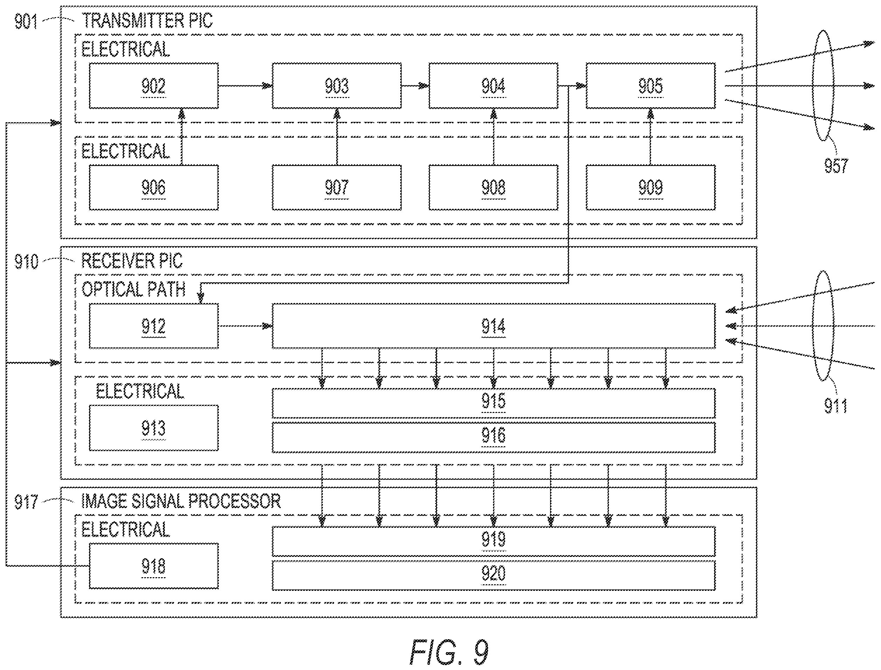

FIG. 9 shows a block diagram of transmitter, receiver and signal processor for a LiDAR based coherent 3D imaging camera.

In one implementation illustrated in FIG. 9 the transmitter 901 is monolithically or hybridly integrated into a single PIC and has the following architecture. A laser source with high coherence 902 with a laser driver 906 is used to provide laser light with fixed optical frequency. The fixed frequency laser signal is coupled into the input of an in-phase quadrature (IQ) modulator 903. A chirped frequency electrical signal generated by the waveform generator or an integrated circuit and amplifier 907 is used to drive the optical IQ modulator and convert the input fixed frequency optical signal into a chirped frequency optical signal, more specifically an optical signal whose frequency changes from f1 to f2 during a time interval t. The chirped frequency optical signal from the output of the optical IQ 903 is passed through the optical amplifier 904 powered by electrical driver 908, in order to be amplified. The optical amplifier may be a semiconductor optical amplifier or a fiber amplifier. The output of the optical amplifier 904 serves as input for the optical beam scanning PIC 905, which then transmits light to one or more external objects by way of a lens 957, according to some example embodiments. The optical beam scanning PIC 905 has an electrical driver 909 associated. In one implementation the optical beam scanning PIC 905 and the beam scanning driver 909 are monolithically integrated on the same optoelectronic chip. In one embodiment the electrical chirp generator, the electrical signal amplifier and the in-phase quadrature optical modulator are monolithically integrated on a single chip. In one embodiment the integration takes place using a silicon on insulator material system or another semiconductor material system. In one embodiment the fixed frequency laser die is integrated with the electrical chirp generator, the electrical signal amplifier and the in-phase quadrature optical modulator using a hybrid approach in which a trench to accommodate the laser is etched into the monolithic silicon on insulator platform. In one embodiment the electrical chirp generator, the electrical signal amplifier for the modulator drive signal, the in-phase quadrature optical modulator, the optical switch network used to scan the optical beam in two dimensions and the driver electronics for the optical switch network are all monolithically integrated on the same chip. In one embodiment the integration platform is a silicon on insulator platform. In one embodiment the integration platform contains a semiconductor material. In one embodiment the fixed frequency laser chip and an optical amplifier or plurality of optical amplifiers are integrated using a hybrid approach on the same chip as the monolithically integrated electrical chirp generator, the electrical signal amplifier for the modulator drive signal, the in-phase quadrature optical modulator, the optical switch network used to scan the optical beam in two dimensions and the driver electronics for the optical switch network. The hybrid integration is achieved using a trench etched into the silicon on insulator platform and the laser and amplifier dies placed into the trench. In one embodiment the integration platform contains a semiconductor material.

In one implementation illustrated in FIG. 9. the coherent receiver array 910 is monolithically or hybridly integrated into a single PIC. The coherent receiver PIC is composed of an array of pixels 914 each pixel being composed of an optical coupler to couple light incident on the chip in the plane of the chip, a 2x2 optical coupler/multiplexer to combine light received from the target with local oscillator and a coherent detector, an optical local oscillator switch network 912 driven by the switch driver 913, a readout amplification stage 915 and an analog interface 916. In one embodiment the optical local oscillator switch network, 912 the switch driver 913, the array of pixels 914, the readout amplification stage 915, and the analog interface 916 are all monolithically integrated on the same chip. In one embodiment the integration platform used is silicon on insulator. In one embodiment the integration platform contains a semiconductor material. A subsegment of the frequency modulated optical signal is split after the optical amplifier 904 and directed to the optical switch network 912 to provide local oscillator optical signal for the array of pixels containing coherent detectors. The light scattered from the region of interest is collimated by lens 911 and directed on one of the pixels containing coherent detectors that compose the array of pixels 914 (e.g., coherent detectors). The return optical signal is combined with local oscillator optical signal. The resulting optical signal is modulated at the frequency of the difference between the two optical signals and is converted into the electrical domain by the photodetectors. The electrical signal is directed to the readout and amplification stages 915 and subsequently to the analog interface 916 to the image signal processor 917. The image signal processor SoC contains a control and synchronization portion 918 which synchronizes the functions of the transmitter and receiver PICs an analog to digital conversion portion 919 which converts the analog electrical signal into a digital signal for a digital signal processing module 920, which performs the FFT on the signal and extracts the signal frequency.

Each coherent detector pixel contains at least a grating and a detector. In this case, the pixel contains two detectors for balanced detection allowing rejection of local oscillator (LO) imperfections. The pixel receives two light signals: one is reflected light from the target that couples into the grating, and the other from the LO signal which was split from the light sent towards the target into a piece that remains local..

For such a receiver array, there are two main advantages of backside illumination over frontside illumination. First, optical transmission and optical beam quality may be improved. When using frontside illumination, light must pass through a complex multi-layered stack of deposited dielectrics that are used as spacer layers in the wiring stack, typically referred to as the BEOL (Back End Of Line) stack. These dielectric layers may not be completely smooth or uniform, scattering and distorting the light beams as they pass through the stack. Meanwhile, in the case of backside illumination, light passes through a single silicon dioxide layer (the buried oxide, referred to as BOX), a single crystalline slab of silicon comprising the substrate, and an anti-reflection (AR) coating. The simpler and better controlled propagation path for light in backside illumination has the potential to have significantly better optical transmission properties. In addition, micro lenses can be deposited on the back side of the wafer to further improve the optical beam characteristics incident on each active region of each pixel of the pixel array and relax the requirements on the FPA collection lens. In one embodiment the micro lens material is highly transparent for the wavelength of operation of the sensor. In one embodiment the micro lenses are patterned with feature sizes commensurate with the pixel size. In one embodiment the micro lens material may contain photoresist though other materials may be used.

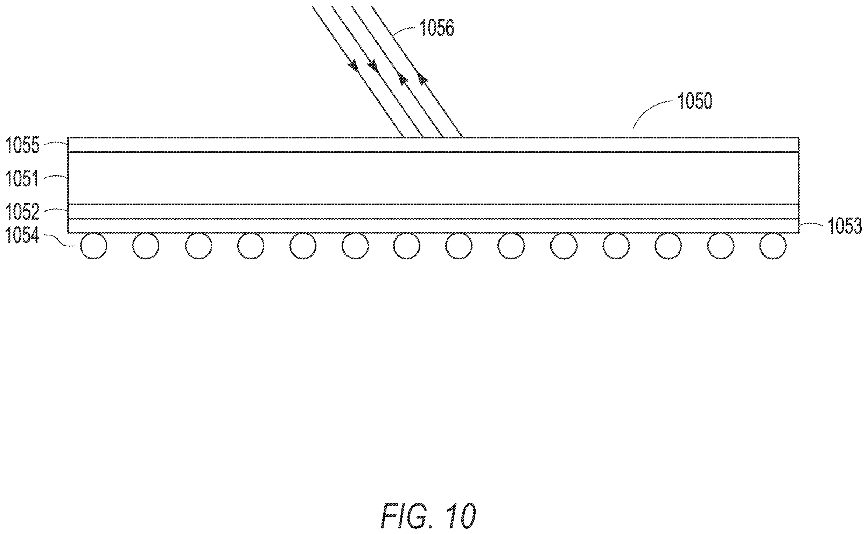

FIG. 10 displays package assembly for monolithically integrated photonics and electronics, according to some example embodiments. The PIC 1050 is flip-chipped to a printed circuit board (PCB) using contacts 1054 (e.g., C4 solder bumps, copper pillars, gold stud bumps), leaving the back surface of the die exposed to transmit and receive light 1056. The backside may have an anti-reflective coating 1055. The PIC 1050 consists of a silicon substrate 1051, silicon dioxide layer referred to as the Buried OXide (BOX) layer 1052, and the active layer 1053 containing all the photonic and electronic components. A receiver array implemented in such a monolithically integrated process can tightly integrate amplifiers, multiplexers, and potentially even analog-to-digital converts directly into the array. This improves both signal integrity and power consumption, especially at high frequencies, since electrical signals need to be transmitted over much shorter distances than if this functionality were implemented off-chip. In addition, this reduces cost since fewer external electronic components are required.

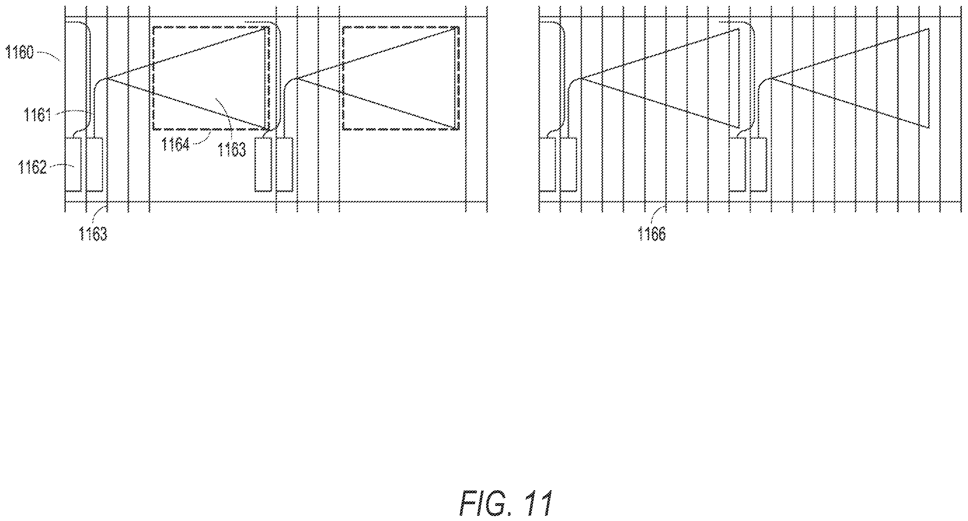

The second and more important advantage of backside illumination is improved packing density of the pixels, as illustrated in FIG. 11. In a frontside-illuminated receiver array, metal wiring must be avoided over the grating couplers in the receiver. The wiring is necessary to connect to the electrical signal generated by the photodiodes, and/or in-pixel electronics to amplify and filter the electrical signal. This, in turn, significantly increases the minimum pitch between pixels in the receiver array, resulting in gaps in the array that may be required for wire routing. Meanwhile, in a backside illuminated receiver, there are absolutely no constraints on the metal wiring, allowing pixels to be packed together more closely. Another benefit of spacing out the global metal wiring is a reduction in crosstalk between pixels as there can be capacitive coupling between long parallel metal wires.

FIG. 11 displays a backside illumination configuration for significantly improving packing density on the chip since wiring can now be placed directly over the grating couplers, according to some example embodiments. On the left-hand side, a front-side illuminated set of pixels 1160, containing a 50-50 coupler 1161, photodiodes 1162, grating coupler 1163, where a large fraction of the area of the pixels 1160 is unavailable for electrical routing since wires 1165 cannot be placed over the grating couplers 1164. On the right-hand side, a backside illuminated architecture 1166 where metal wiring can be placed anywhere over the pixel. Only vertical wiring is shown; however, the same situation occurs for horizontal routing.

Receiver array with monolithically integrated photonics and electronics flip-chip bonded to CMOS chip with support electronics: A backside-illuminated receiver array that incorporates a significant fraction of the electronics signal chain directly into the array was discussed above. This was made possible by a monolithically integrated fabrication process that contains both photonics and electronics. In some cases, however, it may be advantageous to move a large fraction of the electronics signal chain to an electrical integrated circuit (EIC) that is flip - chip bonded to the front-side of the photonic integrated circuit (PIC), as illustrated in FIGs 4 and 5. There are several potential advantages to this approach: The fill-factor of the receiver array can be further improved. Amplifiers and multiplexers that would otherwise take up space in the receiver array, forming gaps between rows of pixels, can be moved to the neighboring EIC; The amplifiers, multiplexers, and ADCs on the EIC can be implemented on a higher-performance process than the PIC, reducing power consumption and improving speed, noise, and other characteristics; and Wiring lengths are reduced, since electrical signals from the PIC are connected directly to the signal processing circuitry (ADCs, etc.) in the EIC via a flip-chip interconnect, rather than through long metal traces on a PCB. This, in turn, reduces power consumption and improves high-speed signal integrity.

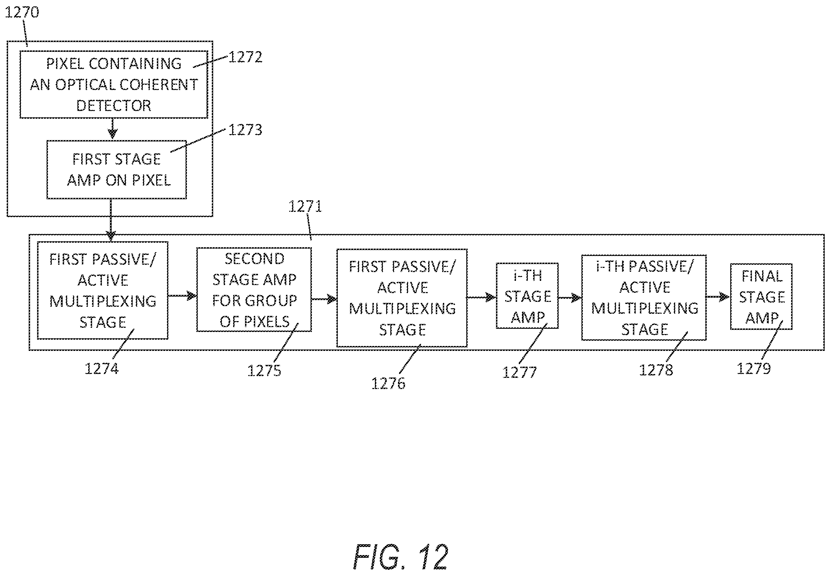

An example implementation of this approach of implementing an assembled PIC / EIC combo with backside illumination is displayed in FIG. 12, according to some example embodiments. The PIC 1270 contains the array of pixels, where each pixel 1272 contains photonic elements, wiring, and interconnect, as well as the first stage amplifier 1273. The EIC 1271 contains the rest of the signal chain to propagate the plurality of pixels and first stage amplifiers to a smaller number of electronic readout channels. Digital conversion of the analog readout signals occurs on a chip different from the EIC. Multiplexing of the per-pixel first stage amplifiers is performed at various stages throughout the signal chain. In one embodiment, each amplifier stage 1273, 1275, 1277 except for the final stage amplifier 1279 is followed by an active and/or passive multiplexing stage 1274, 1276, 1278. The multiplexing stage can be a 2:1, 4:1, 8:1, or higher-order multiplexer in order to reduce the ratio of number of readout channels to the number of pixels. A total number of i amplifier and multiplexer pairs are used where i is typically between 2 and 8, inclusive, depending on the number of pixels in the array and the number of readout channels. In another embodiment, amplifiers may be removed from the signal chain if the signal-to-noise ratio and capacitive loading allows for successive active multiplexers before reaching the next amplifier. In some example embodiments, all amplifiers including the first stage amplifier 1273 are contained on EIC 1271 and the pixels containing the optical coherent detectors are located on PIC 1270.

In the present embodiment, each pixel from the PIC requires only a single direct connection to the EIC by C4 solder bump, copper pillar, Au stud bump, or other flip-chip connector technology to transfer the analog signal information. Since the PIC monolithically integrates photonics with electronics, control signals (e.g. pixel enable), power, and grounds can be connected outside of the imaging array and then processed on the PIC before routing supplies and other signals to each pixel.

In another embodiment, the first passive and/or active multiplexing stage 1274 can be placed on the PIC 1270 and removed from the EIC 1271. Therefore, an interconnect is not required for each pixel, but instead only for the group of pixels shared per multiplexer. Other embodiments can extend the signal chain on the PIC and reduce the amplification and multiplexing required on the EIC and thus further reduce the number of signal interconnections between the PIC and EIC.

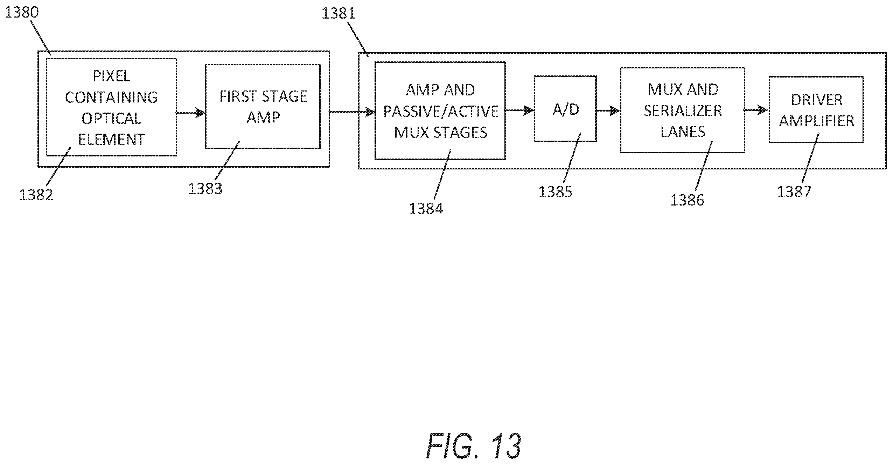

FIG. 13 shows an example implementation of assembled PIC / EIC combo with integrated ADCs, multiplexer, serializer, and driver amplifier for a backside illumination configuration, according to some example embodiments. In this example configuration the ADCs are included on the EIC in order to simplify the overall system design and reduce cost. Similar to FIG. 12, the first stage amplifier 1383 on the PIC 1380 (of FIG. 13) is followed by a cascade of amplifiers and passive/active multiplexers 1384 on the EIC 1381 which map the actively illuminated area of the pixel array 1382 of the PIC 1380 to a fixed number of readout channels. Other embodiments can include the first multiplexing, and/or further amplification and multiplexing stages to reduce the number of signal interconnections between the PIC and EIC. In the present embodiment the number of ADCs 1385 match the number of readout channels. The outputs of the ADCs are further multiplexed and serialized 1386 before being driven off the chip by amplifier 1387 to the image signal processor.

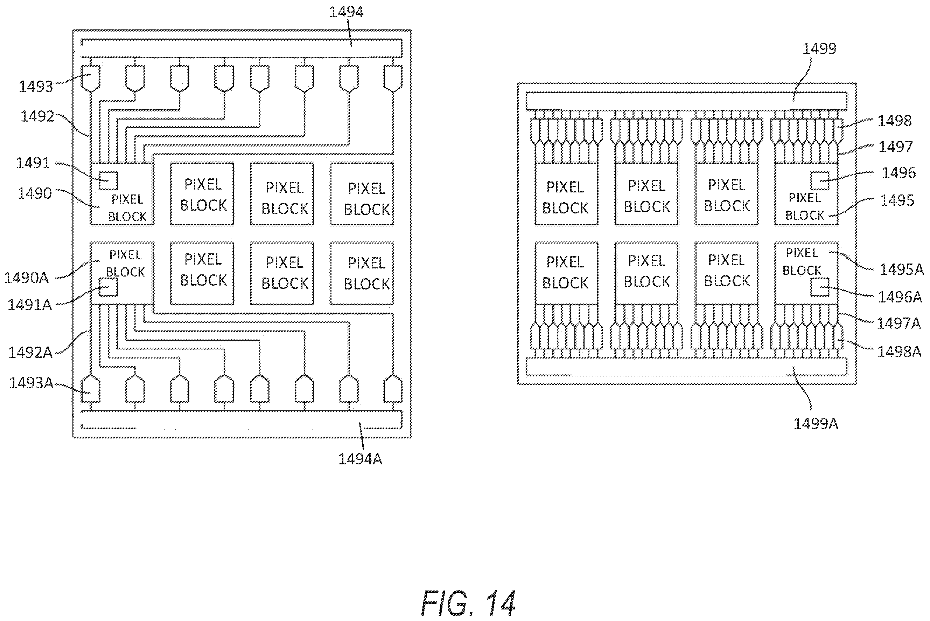

Another view of the present embodiment is shown in FIG. 14. In FIG. 14 the implementation of EICs for backside illumination includes one with one ADC per readout channel architecture, and the other with an excess of ADCs relative to the number of readout channels. The EIC's shared amplifier and multiplexer chains per pixel block 1490 contain sub-blocks of the per pixel amplifiers/multiplexers 1491 that correspond to the actively illuminated pixels on the companion PIC. Only the currently active sub-blocks 1490, 1491, 1490A, 1491A are shown for the present embodiment of 16 readout channels. Bus wires with active signals 1492, 1492A connect the sub-blocks 1491, 1491A to the readout ADCs with input multiplexers 1493, 1493A. Only the bus wiring with active signals are shown; similarly, in this embodiment each Pixel Block has an 8-wire bus connecting the Pixel Block amplifier/multiplexer outputs to corresponding ADCs with input multiplexers. Input multiplexers for each ADC allow selection of the active Pixel Block enabling sharing the ADCs and having the one ADC per readout channel architecture. In another embodiment, 4-wire buses for top and bottom are used for 8 readout channels. In another embodiment there are 32 readout channels. In another embodiment there are 64 readout channels. In another embodiment, the ADCs are only on one side of the EIC, and 4-, 8-, 16-, 32-, or 64-wire buses multiplex at the Pixel Group level to route to the ADCs used for each readout channel. The multiplexer, serializer, and driver blocks 1494, 1494A select the active group of ADCs for data transmission to the image signal processor.

In another possible permutation of the previous embodiments of this approach, one can design the EIC to have an excess of ADCs, as illustrated in FIG. 14. In the previous embodiments, there are single ADC for each readout channel in the array, and multiplexers are used to route the signal to these ADCs. In the present embodiment, there are many more ADCs 1498, 1498A than readout channels for the array, and only a small fraction of the ADCs are turned on at any given time. This allows the number of multiplexer levels to be reduced in each Pixel Block 1495, 1495A, and also reduces the length of metal wires 1497, 1497A through which high-frequency analog signals need to be transmitted. This, in turn, improves signal integrity by minimizing crosstalk, losses, distortion, and noise, and reduces power consumption. The present embodiment shown in FIG. 14 shows each pixel of the active sub-block of pixels 1496, 1496A maps through the amplifier/multiplexer chain to a corresponding ADC 1498. The multiplexer, serializer, and driver blocks 1499, 1499A select the active group of ADCs for data transmission to the image signal processor.

Receiver array with only photonics flip-chip bonded to CMOS chip with support electronics: Above a receiver architectures that made use of a monolithically integrated fabrication process that combines photonic and electronic components onto a single chip was illustrated. Below an alternative architecture in which the photonic integrated circuit (PIC) only contains photonic components, and all electronics components are relegated to an independent electronic integrated circuit (EIC) is discussed. The key advantage of this alternative architecture is that as monolithically integrated electronics are not available in most integrated photonics fabrication processes, this approach would allow for the use of purely photonic manufacturing process.

As illustrated in FIGs 4 and 5, the PIC will be directly attached to the EIC via a flip-chip interconnect. The PIC contains all the photonic components (waveguides, phase shifters, photodiodes, etc.), and collects light through the backside of the PIC. Meanwhile, the EIC contains all the signal chain electronics (amplifiers, multiplexers, ADCs, etc.). Care should be taken to ensure that sensitive components on the PIC (namely, photodiodes), are not placed directly underneath individual flip - chip contacts, since they may be negatively impacted by the stress induced by the flip-chip interconnect.

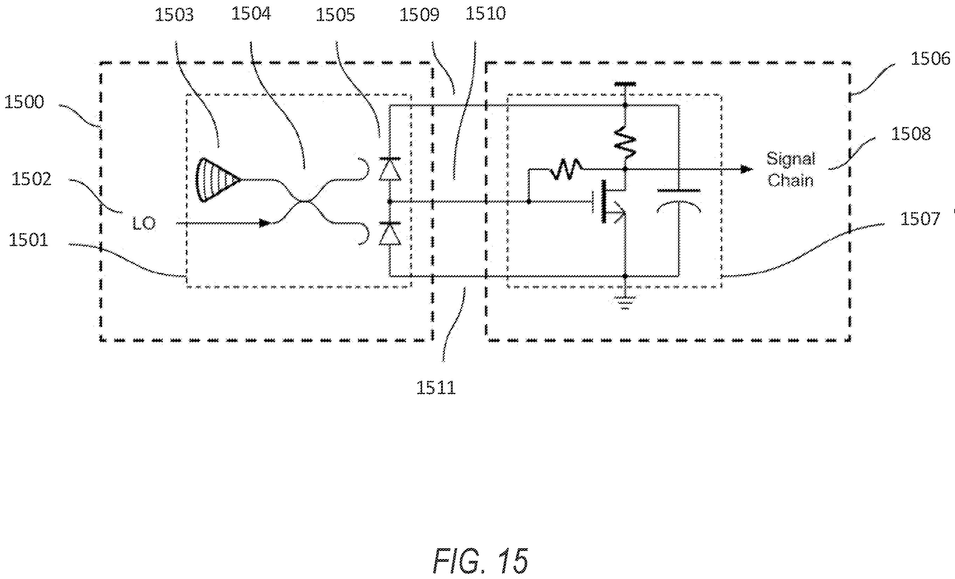

FIG. 15 shows a system with three contacts per pixel, according to some example embodiments. The simplest possible implementation is to use three flip-chip contacts per pixel, as illustrated in FIG. 15. The PIC 1500 contains a plurality of optical pixels 1501, which take in an optical LO signal 1502, which combines with received light 1503 with coupler 1504. The combined optical signal enters balanced detector 1505 which acts to convert the optical signal power to a photocurrent. The EIC 1506 contains a plurality of corresponding electrical pixels 1507 which amplifies electrical signal 1510 to generate the electrical output signal 1508 which goes to the rest of the signal chain. This allows separate ground 1511, photodiode bias 1509, and signal connections 1510 to be made for each pixel. In this scheme, the photodiodes in each pixel are operated in the reverse-biased regime. For an MxN array of pixels, a total of 3xMxN pixel interconnections are needed in addition to further connections for global power, ground, and other control signals. The main advantage of this implementation is that it minimizes crosstalk, since neighboring pixels are not electrically connected to each other on the PIC. The three-contact pixel occupies a relatively large area per pixel due to the large size and pitch of the flip-chip contacts. An example possible aggressive pitch for flip-chip contacts is 40 um, giving a total size of about 120 x 40 um for each three-contact pixel.

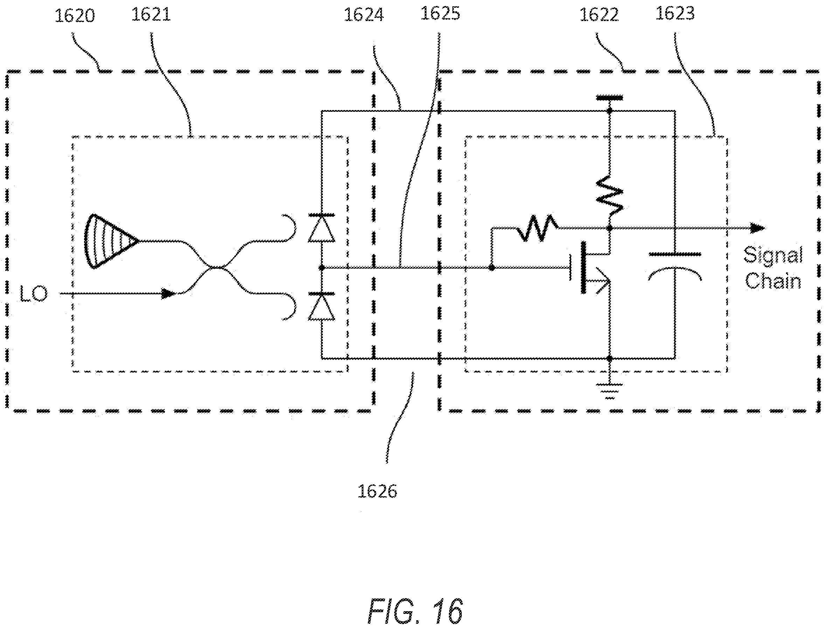

FIG. 16 shows a system with two contacts per pixel with a shared photodiode bias, according to some example embodiments. To reduce the size of each pixel, it is possible to use only two flip-chip contacts per pixel. Given a 40 um contact pitch, this reduces the pixel size to approximately 80 x 40 um. This can be implemented in two different ways. First, photodiode bias can be shared across multiple pixels, while each pixel maintains its own ground and signal connections, as illustrated in FIG. 16. Similar to the embodiment with three connections per pixel previously outlined, the current embodiment connects the PIC 1620 and EIC 1622 at each pixel 1621, 1623 of the plurality of pixels on the PIC and EIC. However, the two connections are the signal 1625 from the balanced detector and one bias, either 1624 or 1626. In the present embodiment shown in FIG. 16 the per pixel bias connection is ground 1626, and a shared bias line 1624 provides reverse-biasing to the balanced detector across a plurality of pixels. In another embodiment, the bias line 1624 is a per-pixel connection, and the ground connection 1626 is shared across a plurality of pixels. In either embodiment described above, the photodiodes operate in the same reverse-biased regime as in the 3-pixel scheme, while using an average of only two flip-chip contacts per pixel. However, this may result in crosstalk between pixels through the photodiode bias connection unless care is taken to isolate the pixels.

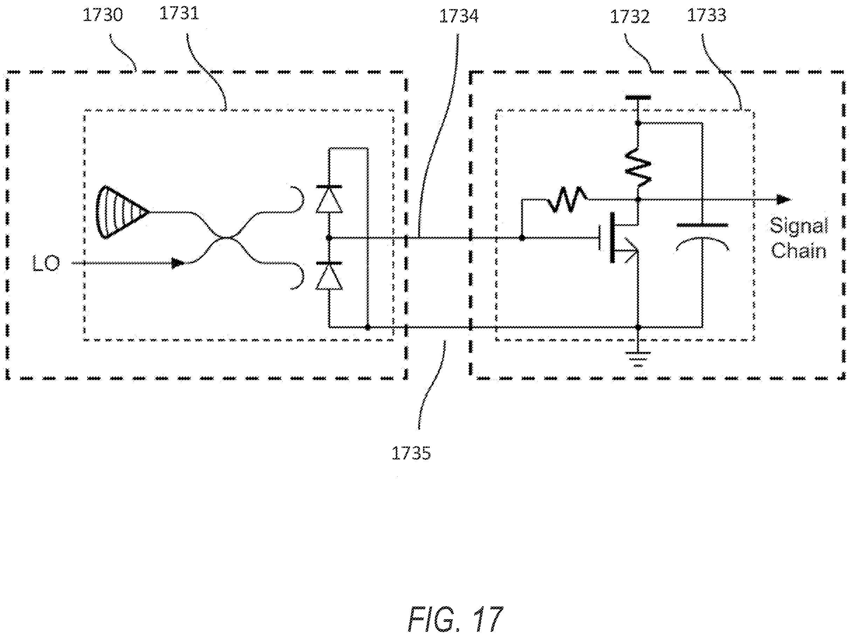

FIG. 17 shows an implementation of two-contact pixel with zero-biased photodiode, according to some example embodiments. The photodiodes in each pixel can be zero-biased. In this scheme, the photodiode bias connection is eliminated, and zero-voltage bias is applied across the photodiodes. The PIC 1730 and EIC 1732 contains the same plurality of optical 1731 and electrical 1733 pixels, but only electrical signal 1734 and ground bias 1735 are connected per pixel between the PIC and EIC. The zero-voltage bias puts the photodiodes in the "solar cell" regime, which is slower than the reverse-biased regime, and has higher dark current compared to the reverse-bias configuration. However, the compact photodiodes used on integrated photonic platforms are still fast enough to pick up LiDAR signals in the 100s of megahertz range, sufficient for target applications ranging from short-range robotics to long-range mapping and object recognition. The advantage of the zero-biasing scheme is that the receiver pixels remain completely electrically isolated on the PIC, minimizing crosstalk.

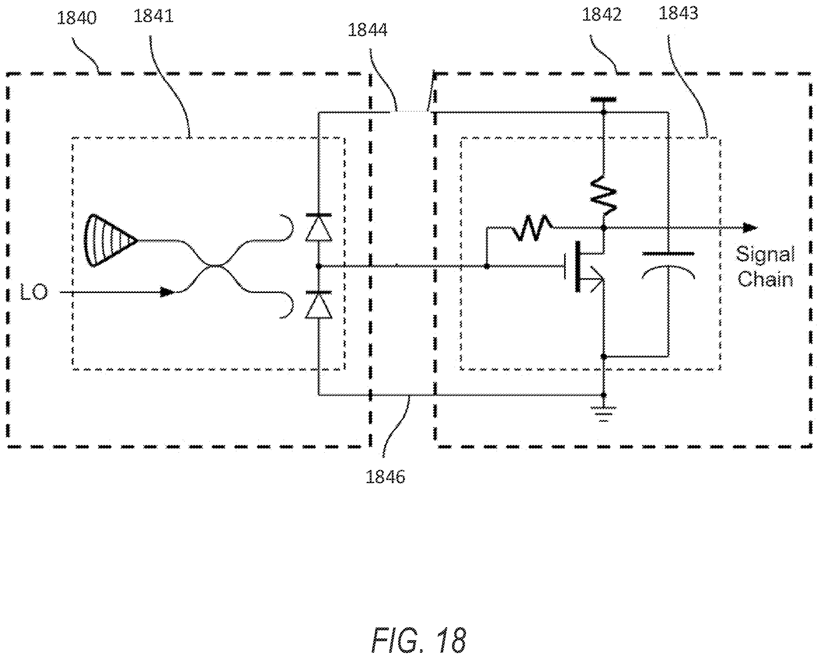

FIG. 18 shows an implementation of single-contact pixel with reverse-biased photodiodes including a PIC 1840 and a EIC 1842, with bias and ground shared across multiple pixels, according to some example embodiments. Further, one can go to a single-contact per pixel architecture, where each pixel only has a single signal connection. Given a 40 um contact pitch, the pixels will only be 40x40 um in size. In a reverse biased configuration, ground 1846 and photodiode bias 1844 can be shared across a plurality of pixels 1841, 1843, as illustrated in FIG. 18.

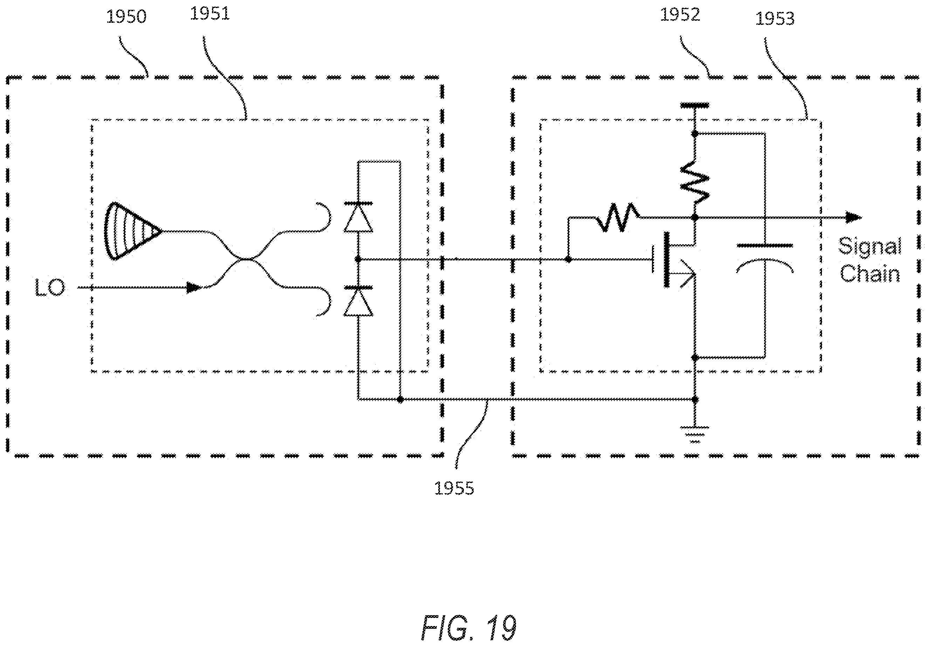

FIG. 19 shows an implementation of single-contact pixel with zero-biased photodiodes with PIC 1950 and EIC 1952, with ground shared across multiple pixels, according to some example embodiments. In a zero-biased configuration, only ground 1955 is shared across pixels 1951, 1953, as illustrated in FIG. 19.

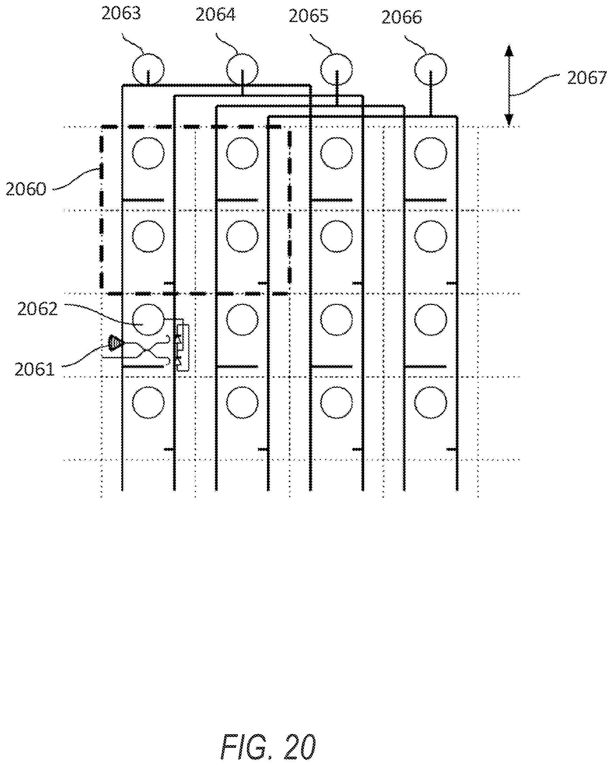

One concern is crosstalk mitigation, since ground and possibly photodiode bias will be shared across multiple pixels. One approach is to share the ground connection across a relatively small blocks of pixels and ensure that only a single photodiode is active at any given time in a single block. This eliminates crosstalk between active pixels, since active pixels will never share electrical connections. One possible implementation of this approach is illustrated in FIG. 20 for a system with groups of 4 pixels active at a time, according to some example embodiments. Namely, each ground bump is only shared amongst 1 active pixel and 3 inactive pixels.

The group of 4 active pixels 2060 is outlined, with 4 unique ground lines. An illustration of the contents of each pixel 2061 shows the signal at the output of the balanced detector connects to the local per-pixel bump 2062. The 4 unique ground bumps 2063, 2064, 2065, 2066 for the shared ground architecture each route to one of the pixels in each 4-pixel grouping. The number of columns that will share grounds is set by the number of active pixels in each group; in the present embodiment of 4 active pixels, 4 columns share the 4 ground bumps. The ground bumps are placed in a routing channel 2067 which may be used for peripheral optical routing on the PIC. The height of 2067 relative to the minimum allowable pitch of bumps also determines the number of columns that will share grounds. In another embodiment, routing channel 2067 can fit two rows of ground bumps, such that for 4-pixel groupings the 4 shared ground bumps occupy two columns. The shared grounds therefore only are used within their respective columns instead of shared across multiple columns. The number of rows with shared ground bumps is independent of the number of pixels per group and the number of rows of ground bumps in the peripheral routing channel.

Transmitter array with only photonics flip-chip bonded to CMOS chip with support electronics: In some example embodiments, light, in a transmitter array, is steered through a tree of optical switches to a plurality of output grating couplers, where for different embodiments there may be 2^N grating couplers where N is between 6 and 14 or larger. One embodiment can include a large plurality of couplers (e.g., 1024 grating couplers). In some example embodiments, a photonic integrated circuit contains only photonic components, and is flip-chip bonded to a supporting electronic integrated circuit (EIC) as illustrated in FIGs 4 and 5. Light from the infrared light emitter array is emitted through the backside of the PIC.

There are at least two advantages for creating a transmitter array with the photonics and electronics on separate chips: One can use a photonics-only fabrication process for the PIC, which is more available than monolithically integrated photonics and electronics processes and typically has higher performance lower loss optical components, and the EIC can be fabricated using a high-voltage process, outputting relatively high control voltages (as high as 10s of volts) to the PIC. Larger control voltages allow the thermo-optic phase shifters in the optical switch tree to be significantly more compact and have significantly lower optical losses. This, in turn, both reduces the size and cost of the PIC, and improves optical transmission through the transmit array.

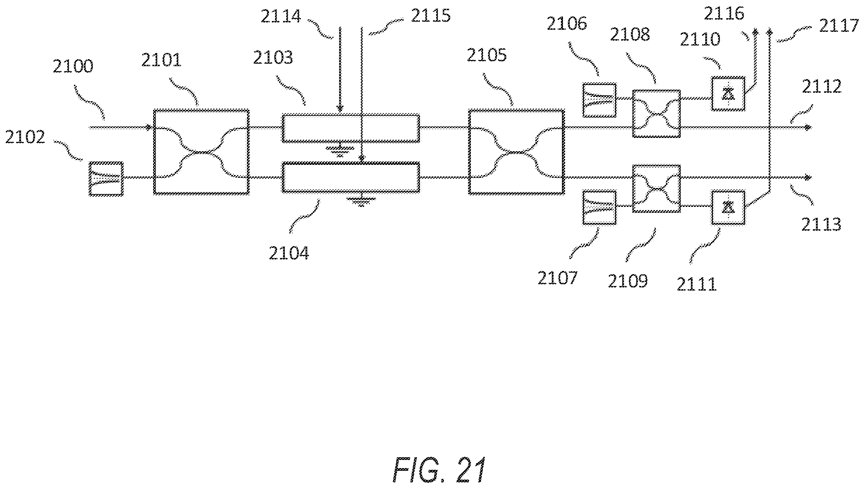

The optical switching network is constructed from a tree of 1x2 optical switches. One implementation of an optical 1x2 switch is illustrated in FIG. 21. Input light is split into two separate waveguides. A differential phase shift is applied to the light propagating through the two waveguides. The light is then recombined on a beamsplitter and directed to two output waveguides.

By varying the relative phase applied to the two internal waveguides, it is possible to control whether light is directed to the first or second output waveguide. The thermo-optic phase shifters used in this optical switch consist of a resistive heating element combined with an optical waveguide. When a voltage is applied to the resistive heating element, the temperature of the waveguide increases, inducing a phase shift in light propagating through the waveguide.

FIG. 21 shows an example implementation of a 1x2 optical switching element, according to some example embodiments.

One embodiment of a thermo-optic switch consists of the optical input signal 2100 going into a 50-50 splitter 2101 (e.g., a 2x2 coupler with one of the inputs unused or connected to an absorber 2102). A thermal phase shifter (TPS) 2103 and 2104 can be placed on each arm capable of at least π/2 phase shift each, or a single TPS one arm capable of π phase shift. Utilizing a TPS on each arm allows a more compact and lower power design. Each TPS can receive an electrical power signal (e.g., drive signal 2114, drive signal 2115) to control the phase shift through the TPS. Another 2x2 coupler 2105 follows, leading to the optical outputs 2112 and 2113. Before the output, the signal can be sensed using asymmetric couplers 2108 and 2109 which would tap 1-5% of the output signal to the sensing photodiodes 2110 and 2111. The unused port of the asymmetric couplers 2108 and 2109 are connected to optical absorbers 2106 and 2107. Each photodiode generates an electrical signal (e.g., electrical photocurrent signal 2116, electrical photocurrent signal 2117) which can be sensed by a control circuit.

In some example embodiments, maximizing the extinction ratio of a thermo-optic switch includes driving one or both of the electrical drive signals 2114 and 2115, and monitoring the photocurrent signals (e.g., electrical photocurrent signal 2116, electrical photocurrent signal 2117) generated in photodiodes 2110 and 2111, respectively, while an optical input signal 2100 is present. By configuring the electrical input signals (e.g., drive signal 2114, drive signal 2115) to drive output signals (e.g., electrical photocurrent signal 2116, electrical photocurrent signal 2117) to either a minimum or maximum, the extinction of the ratio of the thermo-optic switch can be maximized. A feedback control loop which generates the drive signal 2114 and the drive signal 2115 and senses output signals (e.g., electrical photocurrent signal 2116, electrical photocurrent signal 2117) to maximize the extinction ratio can be implemented in a variety of ways but utilizes information from these input and output signals. Subsets of these signals can also enable maximization of the extinction ratio; for example, one embodiment may drive a single TPS on one of the thermo-optic switch, and observe both, one, or neither of the output photocurrents. In the case of neither, one embodiment would directly observe one or both of the optical outputs 2112 and 2113. Feedback control is accomplished by observing and maximizing photocurrent of the desired output, or minimizing the photocurrent of the undesired output. For example, if optical output 2112 is to be maximized, drive signal 2114 and drive signal 2115 are configured such that either the electrical photocurrent signal 2116 is maximized or the electrical photocurrent signal 2117 is minimized, or the ratio of the two is maximized.

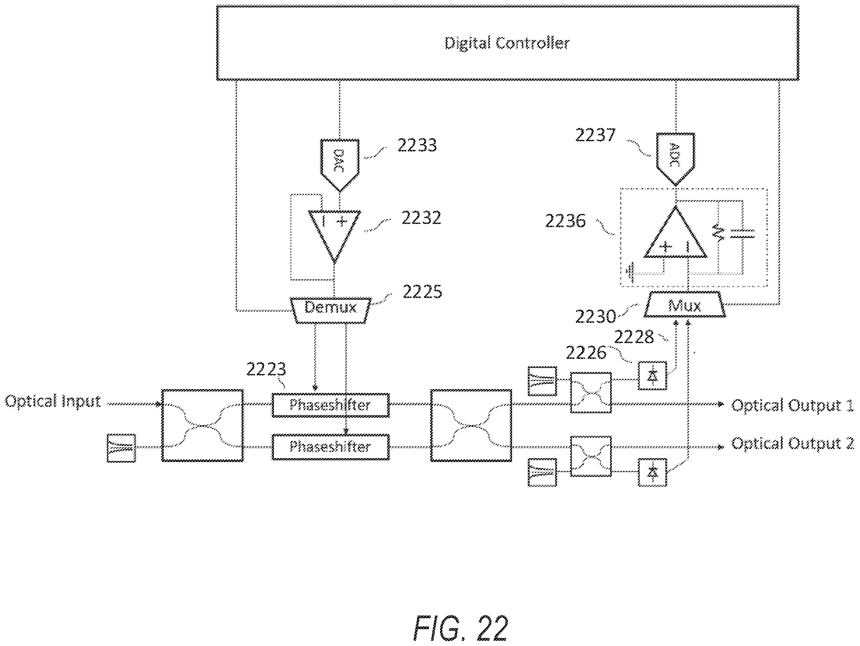

Operating the 1x2 optical switch requires the application of precise control voltages to the integral thermoptic phase shifters. This is achieved by additional monitoring and control circuitry. One embodiment of this control system is illustrated in FIG. 22. Here, a digital controller is used to both monitor where the light is being directed using monitor photodiodes, and apply precise control voltages to the optical phaseshifters. The control voltage is adjusted to maximize the optical power coming out of the desired output waveguide, and/or minimize the optical power coming out of the other output waveguide. The control voltages may either be actively adjusted using a feedback loop during real-time operation, or recorded values from a previous calibration step may be used.

FIG. 22 shows an example implementation of monitor and control circuitry for a 1x2 thermoptic switch, according to some example embodiments. Photocurrent 2228 and 2229) from the monitor photodiodes 2226 and 2227 is amplified by a transimpedance amplifier 2236 before being digitized by an analog-to-digital converter (ADC) 2237 and fed into a digital control system. The monitor photodiodes tap off a small percentage of the output optical signal to convert to electrical signal. An embodiment may asymmetrically tap off 1%, or 5%, or 10% of the light, typically on the lower end of the scale. Based on the signals from the monitor photodiodes, control voltages are applied to the thermoptic phase shifters 2223 and 2224 using a digital-to-analog converter (DAC) 2233 and buffer amplifier 2232. A multiplexer 2230 is used to select between multiple monitor photodiodes, and a demultiplexer 2225 is used to select between multiple phaseshifters, since only a small fraction of the optical switches in a switching tree are in use at any given time. In addition, typically only one phaseshifter is turned on in a 1x2 optical switch at any given time.

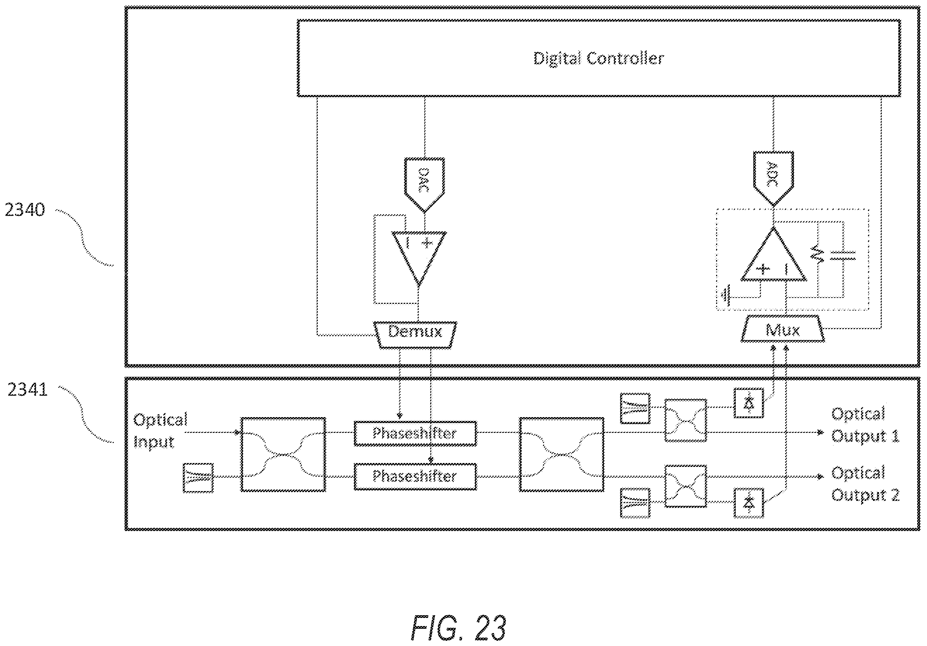

In a monolithically integrated photonics / electronics fabrication process, it may be possible combine both the optical elements and electrical control circuitry onto the same integrated circuit die. However, it is also possible to separate the optical and electrical functions onto separate dies, as illustrated in FIG. 23. As discussed earlier, there are two major advantages to this approach: most photonic fabrication processes do not include electrical components such as transistors, and it enables the use of high control voltages for the thermoptic phase shifters.

FIG. 23 displays an illustration of how the photonics die 2341 can be separated from the electronics 2340 on separate dies, according to some example embodiments. The photonics die 2341 only contains optical components (e.g., thermoptic phase shifters 2223 and 2224 , monitor photodiodes 2226 and 2227). Meanwhile, the electronic die 2340 contains all the analog and digital circuitry required to both monitor and control the optical switch. The electrical integrated circuit (IC) can be fabricated on a standard CMOS process, a high-voltage CMOS process, LDMOS (enabling voltages as high as 60V), or other process.

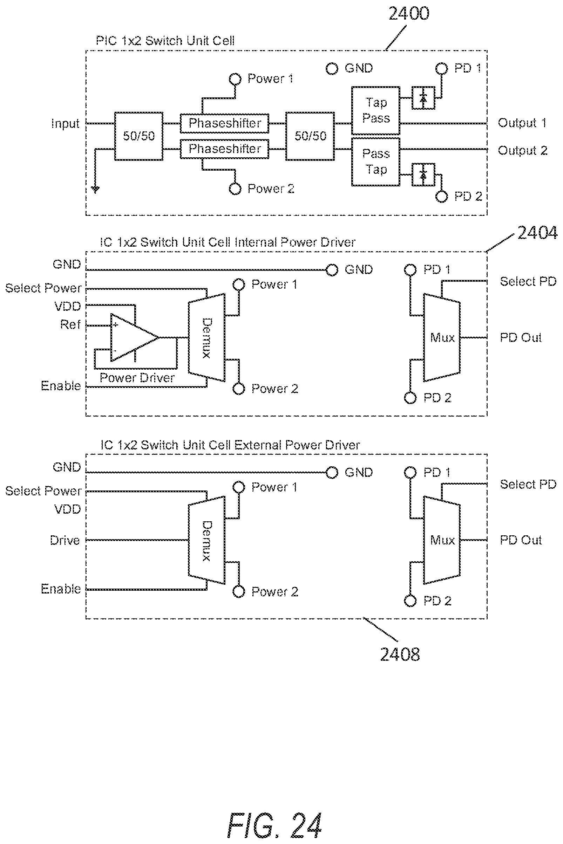

FIG. 24 shows an implementation of unit cells used in an optical switching tree, according to some example embodiments. In some example embodiments, the photonic integrated circuit (PIC) includes an integrated optical switching tree. Further, an electrical integrated circuit (EIC) with all the supporting electronics is attached to the PIC using a flip-chip interconnect. As illustrated in FIG. 24, the tree makes use of matching unit cells on the PIC and EIC. The photonic unit cell (PIC 1x2 Switch Unit Cell) resides on the photonic integrated circuit (PIC). The PIC unit cell 2400 is paired to a matching unit cell on the electronic integrated circuit (EIC) (e.g., EIC unit cell 2404, EIC unit cell 2408) via a flip-chip interconnect, with five connections per unit cell (Power 1, Power 2, GND, PD1, PD2).

In the illustrated example, the PIC unit cell 2400 only contains a single 1x2 optical switch, essentially as described in FIG. 21, containing 50-50 directional couplers, thermoptic phaseshifters, and asymmetric tap directional couplers connected to photodiodes for monitoring and control purposes. Each PIC unit cell contains 5 flip-chip connections to the corresponding EIC unit cell, consisting of ground, one power connection for each of the two thermoptic phaseshifters, and one connection for each of the two monitor photodiodes.

FIG. 24 further displays two embodiments of the EIC unit cell, according to some example embodiments. The EIC unit cell contains the interfacing electronics for a single 1x2 switch, consisting of a multiplexer for the photodiode signals, and a demultiplexer for the power applied to the thermoptic phase shifters. The electrical unit cell can either contain an integrated driver (IC 1x2 Switch Unit Cell Internal Power Driver) as in the EIC unit cell 2404, or it can have an external driver (IC 1x2 Switch Unit Cell External Power Driver) as in the EIC unit cell 2408.

The EIC unit cell 2404 contains an integrated driver for the thermoptic phase shifter (IC 1x2 Switch Unit Cell Internal Power Drivers). The driver is an electrical amplifier that boosts the drive capability of a weakly driven control signal (Ref) from the DAC controlled by the digital control electronics, allowing the signal from the DAC to remain compact. In the embodiment of EIC unit cell 2404, the electrical unit cell has ground (GND), power (VDD), a low-power phase shifter control voltage (Ref), power demultiplexer control signals (Select Power), photodiode multiplexer control signals (Select PD), and a power multiplexer enable signal (Enable) as electrical inputs, and a photodiode signal as an electrical output.

Alternatively, according to another embodiment, the EIC unit cell 2408 is implemented as an IC 1x2 Switch Unit Cell External Power Driver, in which the power drivers are shared between multiple unit cells, and the high-power control signal (Drive) is fed directly into the EIC unit cell 2408. The EIC unit cell 2408 is similar the EIC unit cell 2404 except the power (VDD) and low-power phase shifter control voltage (Ref) are replaced with a single high-power phase shifter control voltage (Drive).

These 1x2 optical switch unit cells can then be cascaded to create a large optical switching tree. Here, one embodiment of a 1024-position switching tree is discussed. However, it is appreciated that any other number of outputs can easily be implemented using the exact same approach, especially powers of 2 such as 4, 8, 16, 32, 64, 128, etc.

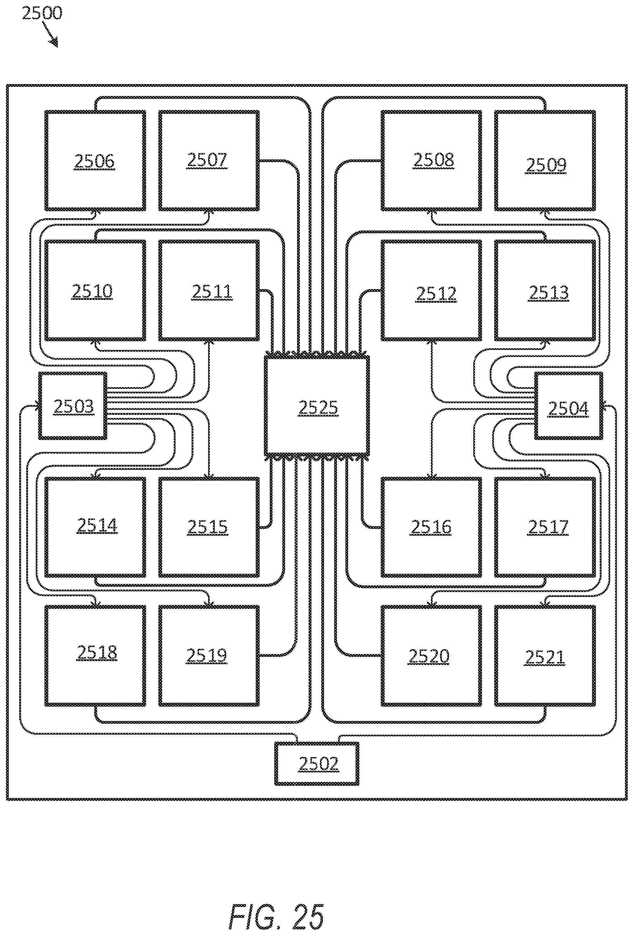

As illustrated in FIG. 25, a transmit array 2500 (e.g., a 1024 transmit array) consists of a number of cascaded 1x2, 1x8, and 1x64 switches that functions as a fanout architecture to separate generated light (e.g., from the infrared light source) to a plurality of light beams to be directed towards external objects. In particular, for example 1x2 switch 2502 is coupled to 1x8 switch 2503 and 1x8 switch 2504, which are coupled to 1x64 switches 2506-2521, which are coupled to a 32x32 grating array 2525.

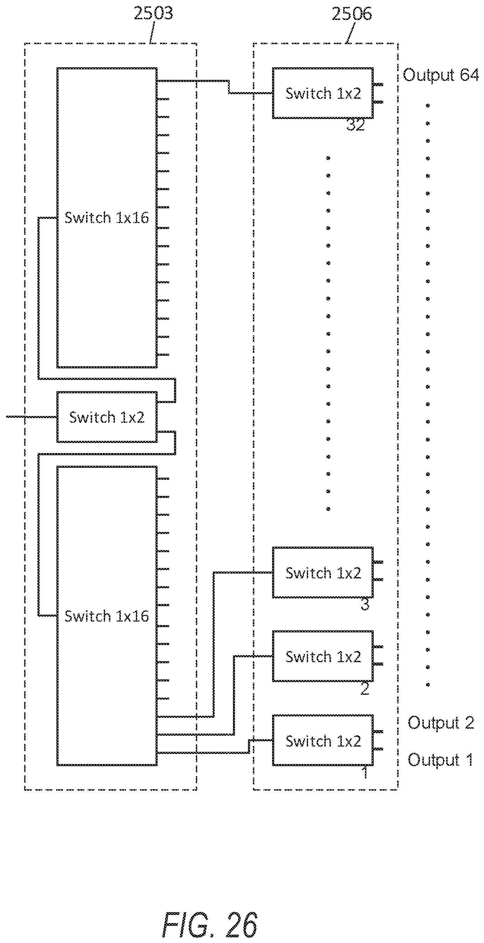

FIG. 26 shows an embodiment of a 1x64 switching tree, according to some example embodiments. The switch requires 6 levels of 1x2 optical switches since 2⁶ = 64. The 1x2 optical switches are stacked in two columns, each containing half of the optical switches. The first five levels of switching are contained in the left column, and the final level of switching occurs in the right column. A wide bus of 64 output waveguides exits the switch to the right. As illustrated in FIG. 26, the 1x8 and 1x64 switches are themselves constructed from cascaded 1x2 switches. The outputs of the optical switches are then routed in large waveguide buses to the center of the 1024 position switch, where they are coupled to free space from a large 32 x 32 array of grating couplers.

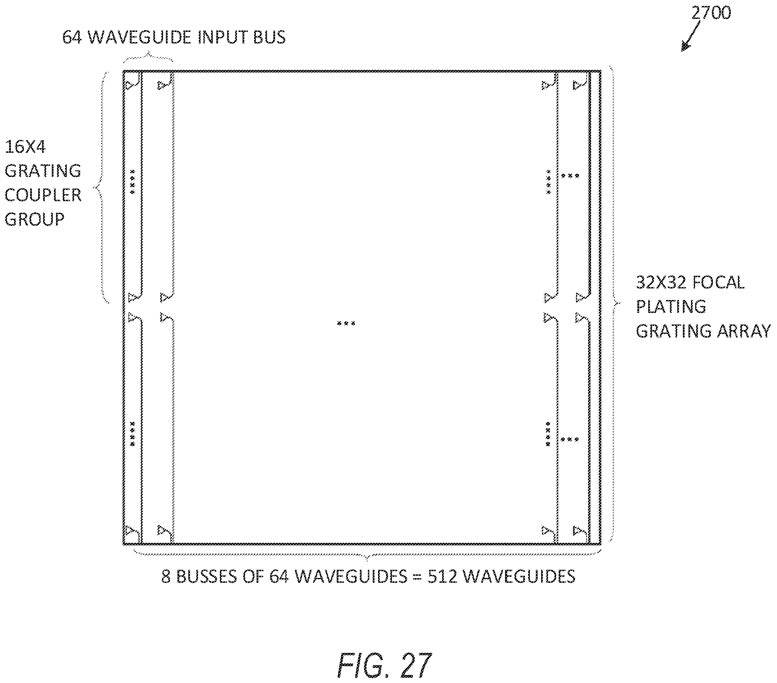

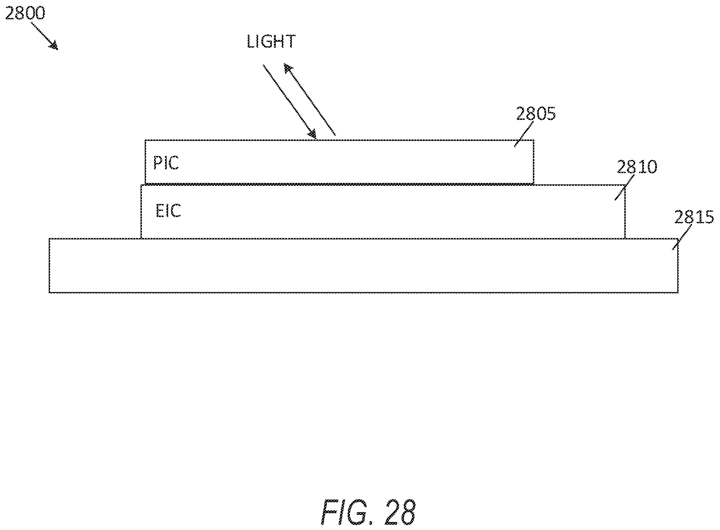

FIG. 27 shows an embodiment of a 32x32 grating array used in a 1024 position transmit array, according to some example embodiments. Light enters the grating array via large buses of optical waveguides from the top and bottom of the array, and are individually routed to output grating couplers. As illustrated in the waveguide architecture 2700 in FIG. 27, the grating array is fed by two wide waveguide buses containing 512 waveguides each. The photonic integrated circuit (PIC) and electronic integrated circuit (EIC) can be physically integrated in several different ways, as outlined in FIGs 28, 29, and 30. All three of these approaches make use of backside illumination, i.e. the grating couplers in the transmit array emit light through the backside of the PIC.

FIG. 28 shows an embodiment of a 1024-position transmit array making use of a direct flip-chip interconnect between the PIC and EIC, according to some example embodiments. The photonic unit cells on the PIC and the electronic unit cells on the EIC are directly aligned with each other, minimizing metal wiring between the unit cells. The EIC is electrically connected to the supporting substrate (printed circuit board, laminate, etc.) either via wire bonds (right-upper) or a flip-chip interconnect (right-lower). The flip-chip interconnect option requires the use of through-silicon vias (TSVs) in the EIC. In the package architecture 2800 in FIG. 28, the PIC 2805 and EIC 2810 can be stacked directly on top of each other using a flip-chip interconnect, with the photonic and electronic unit cells directly aligned with each other. This minimizes the length of wires between the photonic and electronic unit cells, easing the requirements for metal wire routing. The EIC can either use a flip-chip interconnect or wire bonds to interface with the supporting printed circuit board (PCB) 2815 (e.g., laminate, interposer, or another substrate).

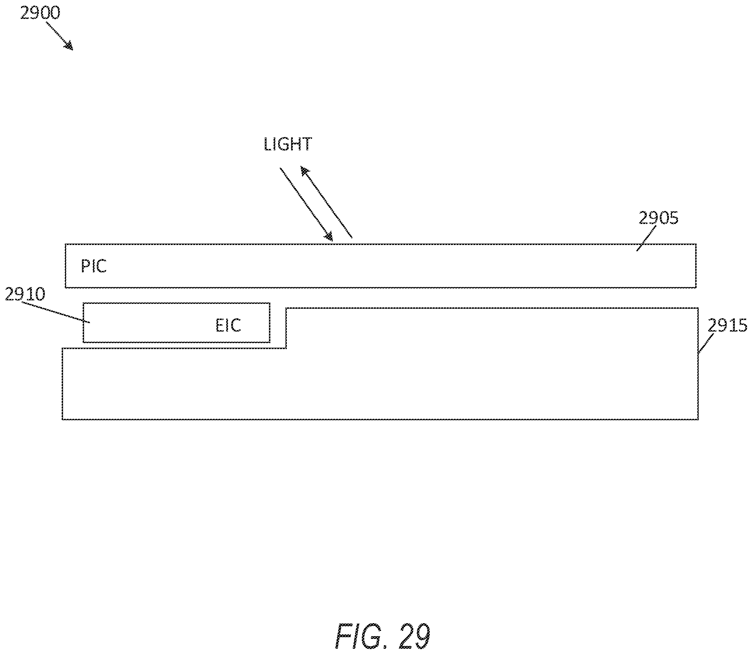

In architecture 2900 that is illustrated in FIG. 29, the EIC die 2910 can be made much smaller than the PIC 2905. The PIC and EIC would still be stacked using a flip-chip interconnect supported by a PCB 2915, but due to the small size of the EIC die 2910, extensive metal wiring in the PIC 2905 is used to connect the photonic and electronic unit cells. Depending on the relative size of the photonic and electronic unit cells, this may be a more cost-effective solution than the previous embodiment since it reduces the size and therefore cost of the EIC. In addition, since the electrical signals are relatively low frequency, operating at frequencies at or below approximately 10 MHz, they are not significantly impacted by the long metal wires required to connect the electrical and photonic unit cells.

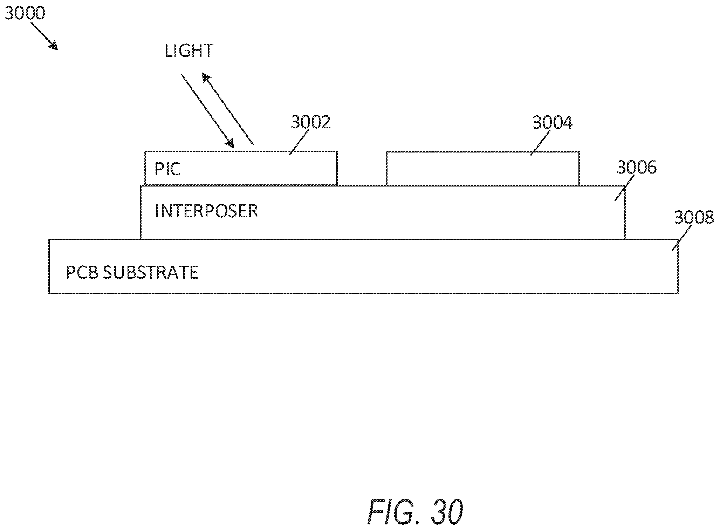

FIG. 30 shows an embodiment of the 1024 position transmit array making use of a high-density interposer, according to some example embodiments. The PIC 3002 and EIC 3004 are both directly attached to the interposer 3006 using a flip-chip interconnect. Meanwhile, the interposer is connected to the supporting substrate (printed circuit board, laminate, etc.) via either wire bonds (upper-right) or a second flip-chip interconnect and vias (lower-right). In the architecture 3000 illustrated in FIG. 30, the EIC die 3004 and PIC die 3002 can both be flip-chipped to a high-density interposer 3006. Electrical signals travel between the EIC 3004 and PIC 3002 through the interposer 3006, supported by the PCB 3008. This approach removes constraints related to the relative size of the EIC and PIC, and the assembly process may be easier than in the previous implementation where the EIC and PIC are directly joined to each other via a flip-chip interconnect.

In the second and third embodiments, the electronic unit cell may be separated into two parts: the portion associated with driving the thermoptic phase shifters, and the portion associated with monitoring the photodiode signals. These can be placed on different locations of the EIC. Since the electronic and photonic unit cells are no longer physically aligned with each other, there is no longer any need for the two portions of the electronic unit cell to be physically adjacent to each other which can lead to a more area-efficient layout of the EIC.

### SINGLE PATH ARCHITECTURES

In a single-path focal-plane array (FPA) LiDAR, the transmit and receive functions are combined into every single pixel. More specifically, the exact same grating couplers are used to both transmit and receive light, and integrated photonic beam splitters (directional couplers) are used to combine the transmit and receive paths. The single-path array closely resembles the receiver array in the dual path architecture, and many of the backside illumination architectures for the receiver array map directly to the single path array. The following descriptions elucidated this approach in more detail, according to some example embodiments.

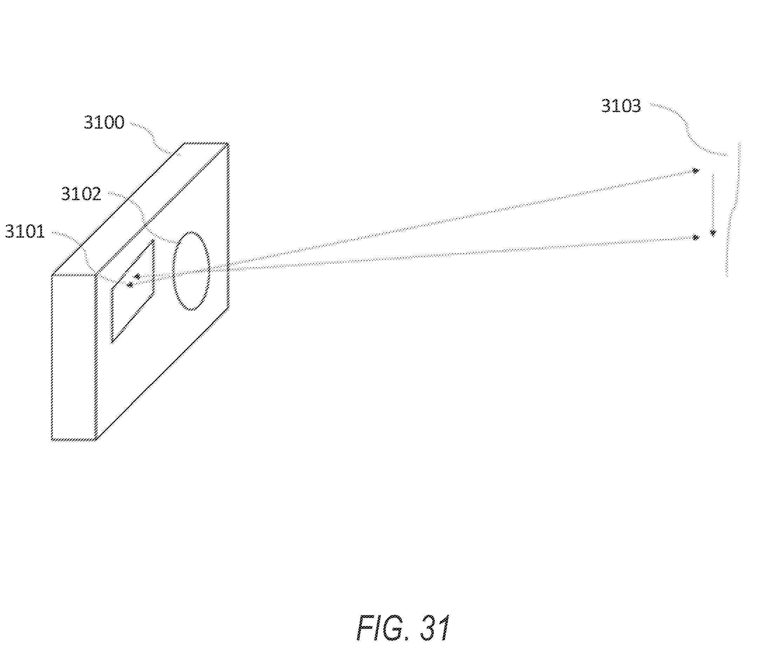

An embodiment of a single-path architecture 3100 is shown in FIG. 31. An optical beam having a modulated optical frequency is directed perpendicular to the transmitter and receiver PIC 3101 successively from a plurality of transmit / receive pixels on the surface of the PIC and collimated with the help of lens 3102 and directed towards the region of interest 3103. Each pixel includes one or more couplers, an optical heterodyne receiver, and optical beam splitters (directional couplers). The function of directing the beam to a plurality of pixels on the surface of the chip is accomplished by an in plane optical switch. The scattered signal from region of interest 3103 is captured by the same lens 3102 and returned to the plurality of pixels located on the surface of the transmitter and receiver PIC 3101where couplers direct the light into the plane of the chip. Once on the plane of the chip the optical signal is combined with a copy of the local optical signal for each pixel of the transmitter / receiver array and the frequency difference between the two signals is measured

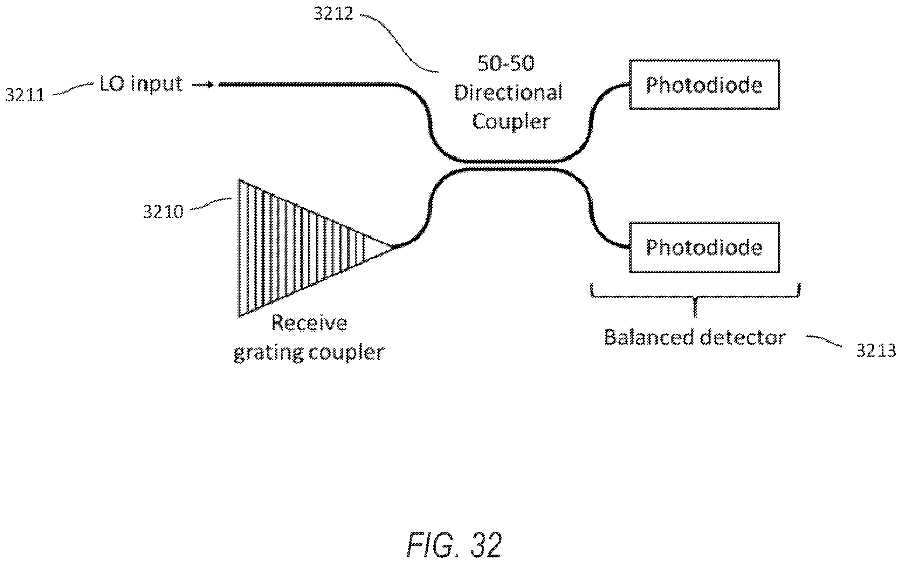

FIG. 32 shows a photonic circuit schematic of an embodiment of a dual-path receiver pixel, according to some example embodiments. Outside light scattered from a target is collected by the receive grating coupler 3210, and combined with local oscillator (LO) laser light 3211 using a 50-50 directional coupler 3212. The two outputs of the directional coupler are directly connected to two photodiodes in a balanced detector configuration 3213, and the generated photocurrent is read out by the receiver electronics.

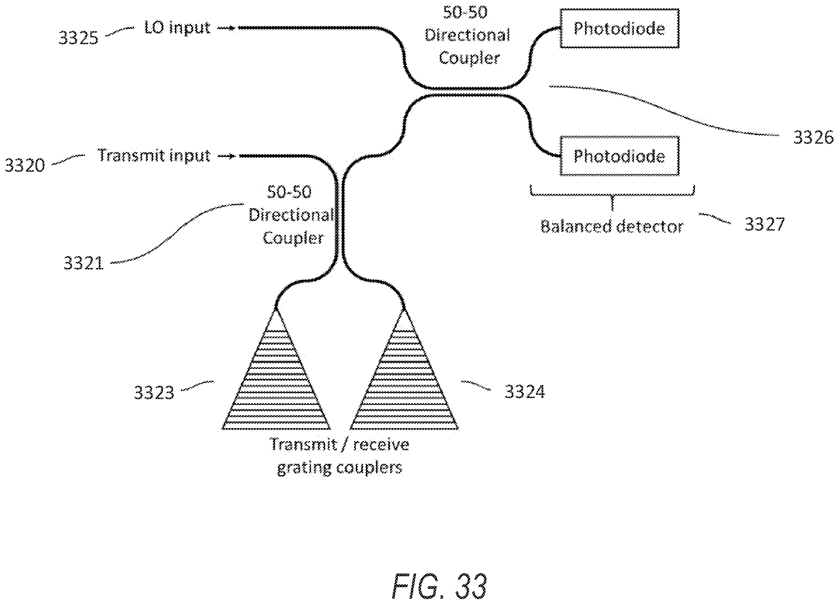

FIG. 33 shows photonic circuit schematic of an embodiment of a single-path transmit / receive pixel, according to some example embodiments. Light from the transmit laser input 3320 is split into two optical waveguides by the first 50-50 directional coupler 3321, and then coupled out of the plane of the chip by the two grating couplers 3323 and 3324. This light is then focused on a target via an external lens (see FIG. 31). Light scattered from the target is then collected by the same grating couplers 3323 and 3324, and directed out of the second (right) port of the first 50-50 directional coupler 3321. The scattered light is then combined with the local oscillator (LO) laser light 3325 using a 50-50 directional coupler 3326. The two outputs of the directional coupler are directly connected to two photodiodes in a balanced detector configuration 3327, and then generated photocurrent is read out by the receiver electronics.

Transmit / receive array with monolithically integrated electronics and photonics: According to some example embodiments, any of the backside illumination architectures for the receiver array discussed above can likewise implemented for the single-path array by replacing the dual-path receiver pixel (FIG. 32) with the single-path transmit-receive pixel (FIG. 33).

Transmit / receive array with monolithically integrated photonics and electronics flip-chip bonded to CMOS chip with support electronics: According to some example embodiments, any of the backside illumination architectures for the receiver array discussed above can be implemented for the single-path array by replacing the dual-path receiver pixel (FIG. 32) with the single-path transmit-receive pixel (FIG. 33).

Transmit / receive with only photonics flip-chip bonded to CMOS chip with support electronics: According to some example embodiments, any of the backside illumination architectures for the receiver array discussed above can be implemented for the single-path array by replacing the dual-path receiver pixel (FIG. 32) with the single-path transmit-receive pixel (FIG. 33).

### GRATING COUPLER DESIGN FOR BACKSIDE ILLUMINATION

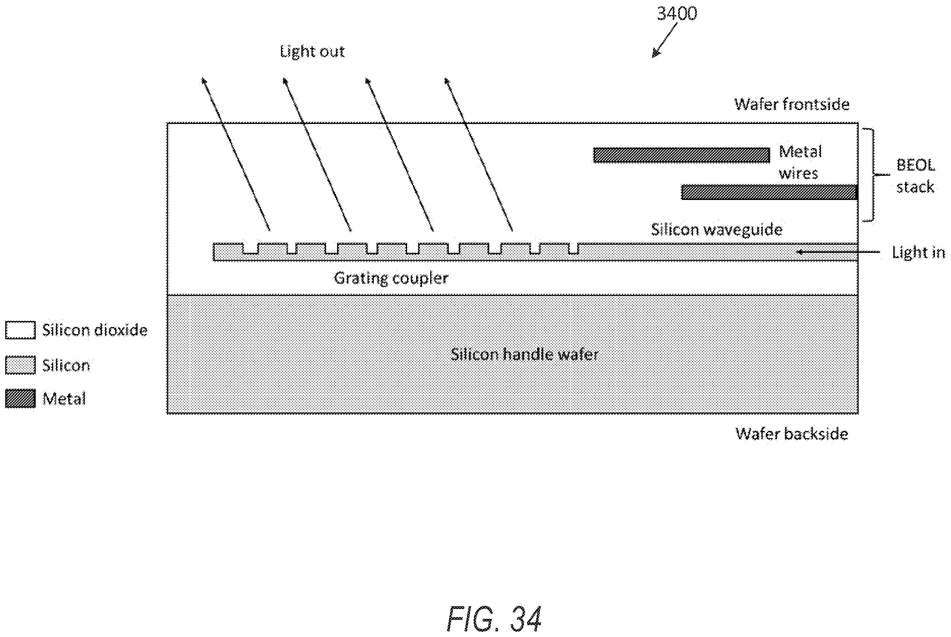

One important component of an FPA-based integrated photonic LiDAR is the grating coupler. In some example embodiments, the grating couplers provided by silicon photonics foundries are designed to emit "upwards", out of the front of the wafer 3400, as illustrated in FIG. 34 FIG. 34 shows a grating coupler on a silicon photonics PIC, according to some example embodiments. Light enters the silicon waveguide from the right, and is coupled out of the waveguide by a series of silicon grooves known as "gratings". The grating grooves are either etched into the silicon waveguide, or deposited on top of the waveguide. Typically, grating couplers are designed to emit light efficiently in the "upwards" direction, out the front side of the die. In this scenario, the light must pass through the BEOL (back end of the line) stack, containing metal wires and insulating spacer layers, to exit the front surface of the wafer / die. The region immediately above the grating coupler must be kept clear of metal wires.

For the backside illuminated LiDAR architectures according to some example embodiments, the grating couplers instead emit light downwards into the semiconductor substrate.

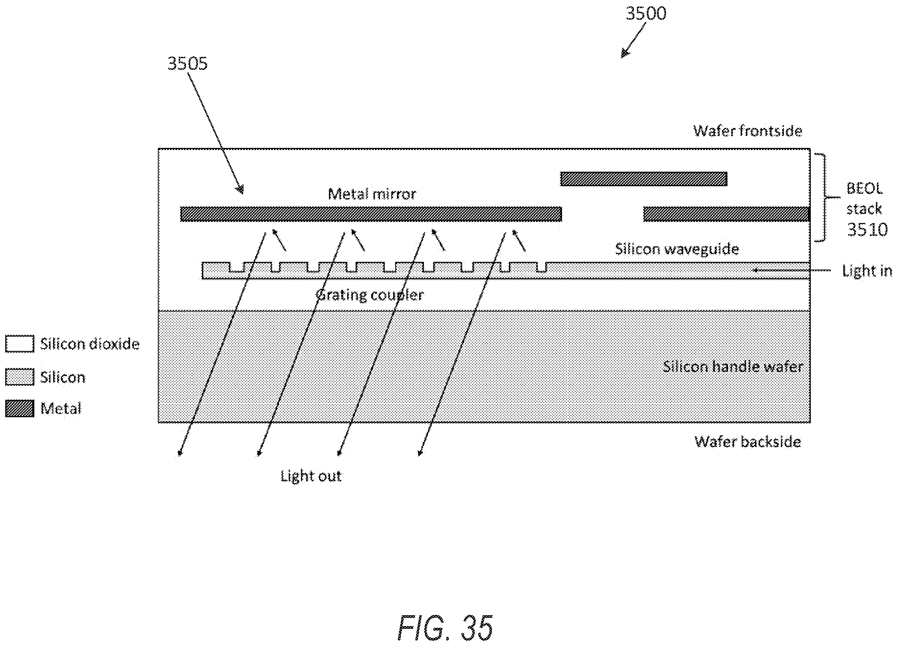

Metal mirror enhanced grating coupler: In the example architecture 3500 that is illustrated in FIG. 35, a metal mirror 3505 immediately above the grating coupler. The light that is emitted upwards by the grating coupler is immediately reflected downwards by the metal mirror 3505. In one approach the first metal wiring layer is repurposed in the BEOL stack 3510 to function as the metal mirror.

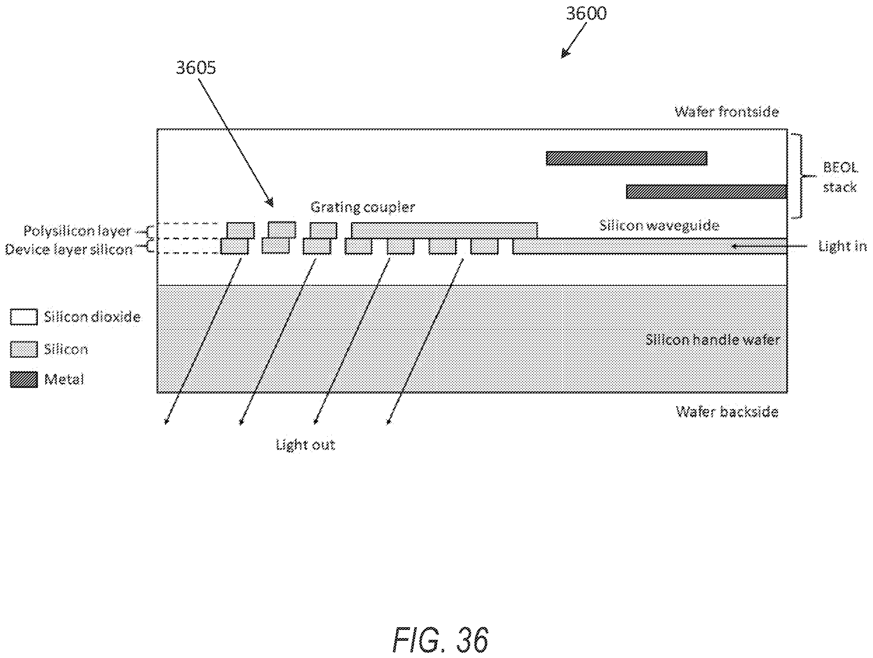

Multi-layer grating coupler: FIG. 36 shows a multi-layered grating coupler 3600, according to some example embodiments. In this approach the coupler consists of multiple independently patterned layers, which can be used to create a highly directional grating coupler 3605 that emits almost all of its light downwards. In one embodiment, the lower layer of the grating coupler consists of the silicon device layer of the silicon-on-insulator (SOI) wafer, and the upper layer consists of polysilicon that is deposited during the fabrication process, according to some example embodiments.

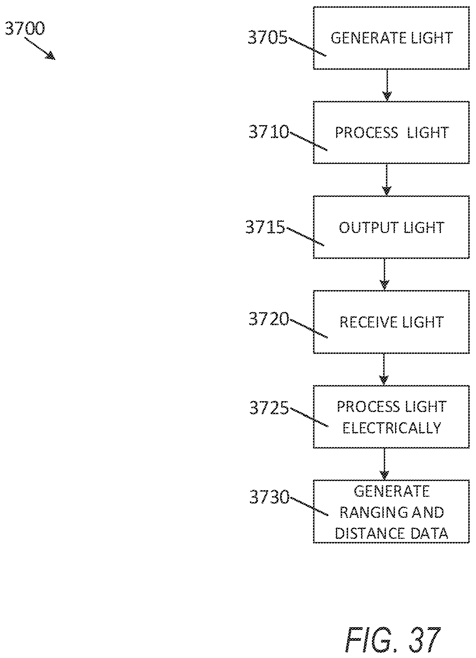

FIG. 37 shows a flow diagram of a method 3700 for implementing a backside LiDAR system to generate ranging and distance data of one or mor external objects, according to some example embodiments. At operation 3705, a backside LiDAR system generates light. For example, as discussed above, one or more infrared light sources (e.g., laser source 902, photonic device layer 293) are integrated in a PIC generate light (e.g., emit infrared light to propagate through the PIC and out a backside). At operation 3710, the backside LiDAR system processes the generated light. For example, the generated light is amplified and separated using a switch tree, according to some example embodiments.

At operation 3715, the generated light is output by the backside LiDAR system. For example, the plurality of separated light beams output by a plurality of couplers (e.g., high density gratings, backside illuminated architecture 1166, FIG. 11) and the light is transmitted through the backside of the backside LiDAR system. At operation 3720, the backside LiDAR system receives the light reflected by one or more external objects. For example, the light is reflected by objects and received by a plurality of receiver pixels in a receiver array in the backside LiDAR system. In some example embodiments, the received light is transmitted through the backside of the backside LiDAR system (e.g., the transmit and receive light are both directed through the backside, where each pixel can both transmit and receive light).

At operation 3725, the received light is electrically processed by an integrated circuit portion of the backside LiDAR system as discussed above. For example, the light is amplified in the PIC and the remaining components in the signal chain are implemented in a EIC that is connected to the PIC (e.g., FIG. 12, FIG. 13), as discussed above. At operation 3730, the backside LiDAR system generates ranging and distance data. For example, at operation 3730 the backside LiDAR system generates a three-dimensional pointcloud image of the external objects, where each point corresponds to one of the receiver pixels of the backside LiDAR system.

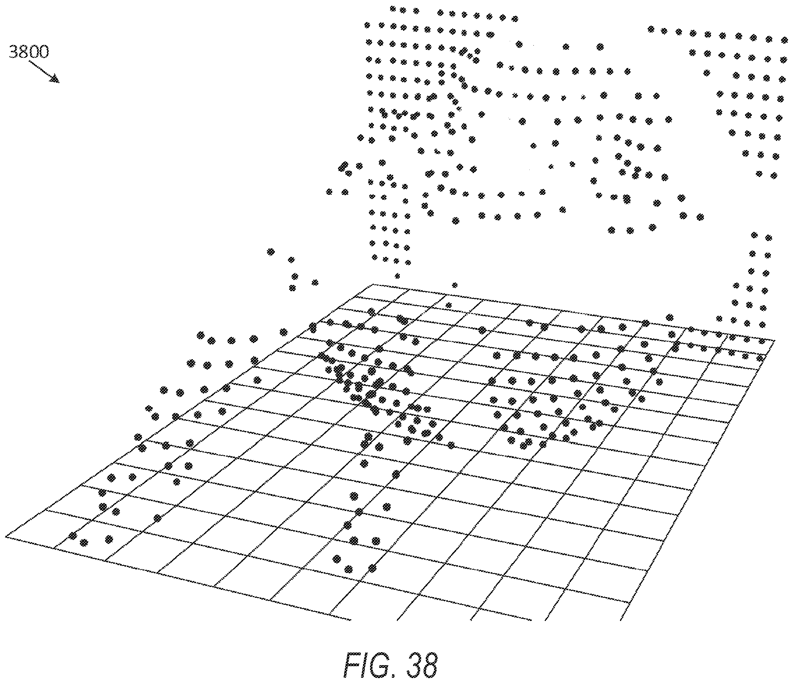

FIG. 38 shows an example pointcloud 3800 generated by the backside LiDAR system, according to some example embodiments. Each of the points in the pointcloud 3800 corresponds to portion of light transmitted to and reflected from one or more external objects (e.g., a man sitting in a round chair). Each of the points corresponds to one pixel in the receiver array as discussed above. For example, infrared light is transmitted to the one or more external objects, and each receiver array element (e.g., pixel) receives reflected light from a
corresponding physical area of the external objects that reflected the light. Each point includes information such as three-dimensional coordinates for the given point (e.g., three orthogonal dimensions; X, Y, Z coordinates from the perspective of the receiver array), and additional data such as velocity information for each given point.

## Claims

1. A backside light detection and ranging system, comprising:
a photonic integrated circuit, PIC, (300; 410; 851, 854; 1050; 3101) comprising a silicon substrate layer (411; 1051), a buried oxide layer (412; 1052), and an active layer (413; 1053), the buried oxide layer (412; 1052) separating the silicon substrate layer (411; 1051) and the active layer (413; 1053), wherein the PIC (410) comprises a light source (851) that emits frequency modulated light from the active layer (413) through the silicon substrate layer (411) towards one or more external objects (855) and a receiver array (854; 3101) that receives reflected frequency modulated light through the silicon substrate layer (411); and
an electronic integrated circuit, EIC, (306; 415) connected to the active layer (413) of the PIC (410), the EIC comprising control circuitry (906, 907, 908, 909) to control and process the frequency modulated light generated in the active layer of the PIC (410) and emitted through the silicon substrate layer (411) towards the one or more external objects (855) and to generate distance and ranging data from the reflected frequency modulated light that is reflected from the one or more external objects (855) and received by the receiver array (854).

2. The backside light detection and ranging system of claim 1, wherein the receiver array (854) is an array of pixels to receive light.

3. The backside light detection and ranging system of claim 1 or claim 2, wherein the distance and ranging data is a pointcloud comprising a plurality of points, each point being generated from frequency modulated light reflected from a corresponding physical area on the one or more external objects (855), each point indicating one or more spatial dimensions of the corresponding physical area.

4. The backside light detection and ranging system of claim 3, wherein the one or more spatial dimensions comprises three orthogonal dimensions.

5. The backside light detection and ranging system of claim 1, wherein the light source (851) is a transmitter array (851; 3101) comprising a plurality of pixels to transmit frequency modulated light towards the one or more external objects (855).

6. The backside light detection and ranging system of claim 1, wherein the light source and the receiver array of the PIC (3101) comprise a plurality of pixels that transmit and receive the frequency modulated light from the one or more external objects.

7. The backside light detection and ranging system of claim 6, wherein each of the pixels comprises one or more gratings.

8. The backside light detection and ranging system of any one of claims 1 to 7, wherein the PIC is a flip-chip PIC that is connected to the EIC using electrical contacts, and wherein a side of the PIC that faces away from the EIC is a backside of the PIC through which the frequency modulated light propagates to the one or more external objects.

9. The backside light detection and ranging system of any one of claims 1 to 8, wherein the PIC further comprises a fanout architecture to separate the frequency modulated light into a plurality of light beams.

10. A method for generating distance and ranging information using a backside light detection and ranging system, the method comprising:
generating (3705), using a photonic integrated circuit, PIC, in the backside light detection and ranging system, frequency modulated light from a light source in an active layer of the PIC, the PIC comprising a silicon substrate layer and a buried oxide layer that separates the silicon substrate layer from the active layer, the frequency modulated light propagating through the silicon substrate layer towards one or more external objects;
receiving (3720), at a receiver array in the active layer of the PIC and through the silicon substrate layer, reflected frequency modulated light that is reflected from the one or more external objects; and
generating (3730), using an electronic integrated circuit, EIC, in the backside light detection and ranging system, ranging data from the received reflected frequency modulated light, the EIC comprising control circuitry to control and process the frequency modulated light generated in the active layer of the PIC and emitted through the silicon substrate layer towards the one or more external objects and to generate the ranging data.

11. The method of claim 10, wherein the frequency modulated light is emitted from a transmitter array comprising a plurality of pixels to transmit frequency modulated light towards the one or more external objects.

12. The method of claim 10 or claim 11, wherein the PIC comprises a plurality of pixels that transmit and receive the frequency modulated light from the one or more external objects.

13. The method of any one of claims 10 to 12, wherein the PIC is a flip-chip PIC that is connected to the EIC using electrical contacts, and wherein a side of the PIC that faces away from the EIC is a backside of the PIC through which the frequency modulated light propagates to the one or more external objects.

## Patentansprüche

1. Ein System zur Lichtdetektion und Entfernungsmessung von der Rückseite, umfassend:
eine photonische integrierte Schaltung, PIC, (300; 410; 851, 854; 1050; 3101) mit einer Siliziumsubstratschicht (411; 1051), einer vergrabenen Oxidschicht (412; 1052) und einer aktiven Schicht (413; 1053), wobei die vergrabene Oxidschicht (412; 1052) die Siliziumsubstratschicht (411; 1051) und die aktive Schicht (413; 1053) trennt, wobei die PIC (410) eine Lichtquelle (851) aufweist, die frequenzmoduliertes Licht von der aktiven Schicht (413) durch die Siliziumsubstratschicht (411) zu einem oder mehreren externen Objekten (855) emittiert, und ein Empfängerarray (854; 3101), das reflektiertes frequenzmoduliertes Licht durch die Siliziumsubstratschicht (411) empfängt; und
eine elektronische integrierte Schaltung, EIC, (306; 415), die mit der aktiven Schicht (413) der PIC (410) verbunden ist, wobei die EIC eine Steuerschaltung (906, 907, 908, 909) aufweist zum Steuern und Verarbeiten des frequenzmodulierten Lichts, das in der aktiven Schicht der PIC (410) erzeugt und durch die Siliziumsubstratschicht (411) in Richtung des einen oder der mehreren externen Objekte (855) emittiert wird, und zum Erzeugen von Entfernungs- und Entfernungsmessdaten aus dem reflektierten frequenzmodulierten Licht, das von dem einen oder den mehreren externen Objekten (855) reflektiert und vom Empfängerarray (854) empfangen wird.

2. Das System zur Lichtdetektion und Entfernungsmessung nach Anspruch 1, wobei das Empfängerarray (854) ein Array von Pixeln zum Empfangen von Licht ist.

3. Das System zur Lichtdetektion und Entfernungsmessung nach Anspruch 1 oder Anspruch 2, wobei die Entfernungs- und Entfernungsmessdaten eine Punktwolke sind, die eine Vielzahl von Punkten umfasst, wobei jeder Punkt aus frequenzmoduliertem Licht erzeugt wird, das von einem entsprechenden physikalischen Bereich auf dem einen oder den mehreren externen Objekten (855) reflektiert wird, wobei jeder Punkt eine oder mehrere räumliche Dimensionen des entsprechenden physikalischen Bereichs angibt.

4. Das System zur Lichtdetektion und Entfernungsmessung nach Anspruch 3, wobei die eine oder mehreren räumlichen Dimensionen drei orthogonale Dimensionen umfassen.

5. Das System zur Lichtdetektion und Entfernungsmessung nach Anspruch 1, wobei die Lichtquelle (851) ein Senderarray (851; 3101) ist, die eine Vielzahl von Pixeln umfasst, um frequenzmoduliertes Licht zu dem einen oder den mehreren externen Objekten (855) zu senden.

6. Das System zur Lichtdetektion und Entfernungsmessung nach Anspruch 1, wobei die Lichtquelle und das Empfängerarray der PIC (3101) eine Vielzahl von Pixeln umfassen, die das frequenzmodulierte Licht von dem einen oder den mehreren externen Objekten senden und empfangen.

7. Das System zur Lichtdetektion und Entfernungsmessung nach Anspruch 6, wobei jedes der Pixel ein oder mehrere Gitter umfasst.

8. Das System zur Lichtdetektion und Entfernungsmessung nach einem der Ansprüche 1 bis 7, wobei die PIC eine Flip-Chip-PIC ist, die über elektrische Kontakte mit der EIC verbunden ist, und wobei eine Seite der PIC, die von der EIC weggerichtet ist, eine Rückseite der PIC ist, durch die sich das frequenzmodulierte Licht zu dem einen oder den mehreren externen Objekten ausbreitet.

9. Das System zur Lichtdetektion und Entfernungsmessung nach einem der Ansprüche 1 bis 8, wobei die PIC ferner eine Fanout-Architektur umfasst, um das frequenzmodulierte Licht in eine Vielzahl von Lichtstrahlen aufzutrennen.

10. Verfahren zum Erzeugen von Entfernungsinformation und Entfernungsmessinformationen unter Verwendung eines Systems zur Lichtdetektion und Entfernungsmessung von der Rückseite, wobei das Verfahren umfasst:
Erzeugen (3705), unter Verwendung einer photonischen integrierten Schaltung, PIC, im System zur Lichtdetektion und Entfernungsmessung von der Rückseite, von frequenzmoduliertem Licht aus einer Lichtquelle in einer aktiven Schicht der PIC, wobei die PIC eine Siliziumsubstratschicht und eine vergrabene Oxidschicht aufweist, die die Siliziumsubstratschicht von der aktiven Schicht trennt, wobei sich das frequenzmodulierte Licht durch die Siliziumsubstratschicht zu einem oder mehreren externen Objekten ausbreitet;
Empfangen (3720), in einem Empfängerarray in der aktiven Schicht der PIC und durch die Siliziumsubstratschicht hindurch, von reflektiertem frequenzmoduliertem Licht, das von dem einen oder den mehreren externen Objekten reflektiert wird; und Erzeugen (3730), unter Verwendung einer elektronischen integrierten Schaltung EIC in dem rückseitigen Lichtdetektions- und Entfernungsmesssystem, von Entfernungsdaten aus dem empfangenen reflektierten frequenzmodulierten Licht , wobei die EIC eine Steuerschaltung zum Steuern und Verarbeiten des in der aktiven Schicht der PIC erzeugten und durch die Siliziumsubstratschicht hindurch in Richtung des einen oder der mehreren externen Objekte emittierten frequenzmodulierten Lichts und zum Erzeugen der Entfernungsdaten aufweist.

11. Verfahren nach Anspruch 10, wobei das frequenzmodulierte Licht von einem Senderarray ausgesendet wird, das eine Vielzahl von Pixeln umfasst, um frequenzmoduliertes Licht zu dem einen oder den mehreren externen Objekten zu senden.

12. Verfahren nach Anspruch 10 oder Anspruch 11, wobei die PIC eine Vielzahl von Pixeln umfasst, die das frequenzmodulierte Licht von dem einen oder den mehreren externen Objekten senden und empfangen.

13. Verfahren nach einem der Ansprüche 10 bis 12, wobei die PIC eine Flip-Chip-PIC ist, die über elektrische Kontakte mit der EIC verbunden ist, und wobei eine Seite der PIC, die von der EIC weggerichtet ist, eine Rückseite der PIC ist, durch die sich das frequenzmodulierte Licht zu dem einen oder den mehreren externen Objekten ausbreitet.

## Revendications

1. Un système de détection et de télémétrie par lumière arrière, comprenant :
un circuit intégré photonique, PIC, (300; 410; 851; 854; 1050; 3101) comprenant une couche de substrat en silicium (411; 1051), une couche d'oxyde noyée (412; 1052) et une couche active (413; 1053), dans lequel la couche d'oxyde noyée (412; 1052) sépare la couche de substrat en silicium (411; 1051) et la couche active(413; 1053), dans lequel le PIC (410) comprend une source de lumière (851) qui émet de la lumière modulée en fréquence depuis la couche active (413) à travers la couche de substrat en silicium (411) vers un ou plusieurs objets externes (55) eu un réseau de récepteurs (854; 3101) qui reçoit de la lumière modulée en fréquence à travers la couche de substrat en silicium (411) ; et
un circuit intégré électronique, EIC, (306; 415) connecté à la couche active (413) du PIC (410), dans lequel l'EIC comprend des circuits de commande (906, 907, 908, 909) pour commander et traiter la lumière modulée en fréquence générée dans la couche active du PIC (410) et émise à travers la couche de substrat en silicium vers l'un ou les plusieurs objets externes (855) et pour générer des données de distance et de télémétrie à partir de la lumière modulée en fréquence réfléchie par l'un ou les plusieurs objets externes (855) et reçue par le réseau de récepteurs (854).

2. Le système de détection et de télémétrie par lumière arrière selon la revendication 1, dans lequel le réseau de récepteurs (854) est un réseau de pixels destiné à recevoir la lumière.

3. Le système de détection et de télémétrie par lumière arrière selon la revendication 1 ou 2, dans lequel les données de distance et de télémétrie sont un nuage de points comprenant une pluralité de points, dans lequel chaque point est généré à partir de lumière modulée en fréquence réfléchie par une zone physique correspondante sur l'un ou les plusieurs objets externes (855), dans lequel chaque point indique une ou plusieurs dimensions spatiales de la zone physique correspondante.

4. Le système de détection et de télémétrie par lumière arrière selon la revendication 3, dans lequel l'une ou les plusieurs dimensions spatiales comprennent trois dimensions orthogonales.

5. Le système de détection et de télémétrie par lumière arrière selon la revendication 1, dans lequel la source de lumière (851) est un réseau d'émetteurs (851; 3101) comprenant une pluralité de pixels qui émettent et reçoivent la lumière modulée en fréquence provenant de l'un ou des plusieurs objets externes.

6. Le système de détection et de télémétrie par lumière arrière selon la revendication 1, dans lequel la source de lumière et le réseau de récepteurs du PIC (3101) comprennent une pluralité de pixels qui émettent et reçoivent la lumière modulée en fréquence à partir de l'un ou des plusieurs objets externes.

7. Le système de détection et de télémétrie par lumière arrière selon la revendication 6, dans lequel chacun des pixels comprend un ou plusieurs réseaux.

8. Le système de détection et de télémétrie de lumière arrière selon l'une des revendications 1 à 7, dans lequel le PIC est un PIC à puce retournée qui est connecté à l'EIC à l'aide de contacts électriques, et dans lequel un côté du PIC qui est opposé à l'EIC est une face arrière du PIC à travers laquelle la lumière transmise se propage vers l'un ou les plusieurs objets externes.

9. Le système de détection et de télémétrie de lumière arrière selon l'une des revendications 1 à 8, dans lequel le PIC comprend en outre une architecture en éventail pour séparer la lumière modulée en fréquence en une pluralité de faisceaux de lumière.

10. Un procédé pour générer des informations de distance et de télémétrie à l'aide d'un système de détection et de télémétrie de lumière arrière, le procédé comprenant :
générer (3705), à l'aide d'un circuit intégré photonique, PIC, dans le système de détection et de télémétrie par la lumière arrière, d'une lumière modulée en fréquence à partir d'une source de lumière dans une couche active du PIC, le PIC comprenant une couche de substrat en silicium et une couche d'oxyde noyée séparant la couche de substrat en silicium et la couche active, la lumière modulée en fréquence se propageant à travers la couche de substrat en silicium vers un ou plusieurs objets externes ;
recevoir (3720), à un réseau de récepteurs dans la couche active du PIC et à travers la couche de substrat en silicium, de la lumière modulée en fréquence réfléchie de l'un ou des plusieurs objets externes ; et
générer (3730), à l'aide d'un circuit intégré électronique, EIC, dans le système de détection et de télémétrie par lumière arrière, des données de télémétrie à partir de la lumière modulée en fréquence réfléchie, l'EIC comprenant des circuits de commande pour commander et traiter la lumière modulée en fréquence générée dans la couche active du PIC et émise à travers la couche de substrat en silicium vers l'un ou les plusieurs objets externes et de générer les données de télémétrie.

11. Le procédé selon la revendication 10, dans lequel la lumière modulée en fréquence est émise à partir d'un réseau d'émetteurs comprenant une pluralité de pixels pour transmettre la lumière vers l'un ou les plusieurs objets externes.

12. Le procédé selon la revendication 10 ou la revendication 11, dans lequel le PIC comprend une pluralité de pixels qui transmettent et reçoivent la lumière modulée en fréquence provenant de l'un ou des plusieurs objets externes.

13. Le procédé selon l'une des revendications 10 à 12, dans lequel le PIC est un PIC à puce retournée qui est connecté à l'EIC à l'aide de contacts électriques, et dans lequel un côté du PIC qui est opposé à l'EIC est une face arrière du PIC à travers laquelle la lumière transmise se propage vers le ou les objets externes.
